# EUROPEAN PATENT SPECIFICATION

(11) **EP 4 213 213 B1**
(45) Date of publication and mention of the grant of the patent: **06.05.2026**
(21) Application number: 20956955.7
(22) Date of filing: 12.10.2020
(51) Int. Cl.: H10K 59/131, G09G 3/20, G02F 1/1345, H10K 59/121

(54) **DISPLAY PANEL AND MANUFACTURING METHOD THEREFOR, AND DISPLAY DEVICE**
ANZEIGETAFEL UND HERSTELLUNGSVERFAHREN DAFÜR SOWIE ANZEIGEVORRICHTUNG
PANNEAU D'AFFICHAGE ET SON PROCÉDÉ DE FABRICATION, ET DISPOSITIF D'AFFICHAGE

(43) Date of publication of application: 19.07.2023
(73) Proprietor: BOE Technology Group Co., Ltd., Beijing 100015 (CN); Chengdu BOE Optoelectronics Technology Co., Ltd., Chengdu, Sichuan 611731 (CN)
(72) Inventor: HUANG, Weiyun, Beijing 100176 (CN); WU, Chao, Beijing 100176 (CN); LONG, Yue, Beijing 100176 (CN)
(74) Representative: Cohausz & Florack
(86) International application number: PCT/CN2020/120452
(87) International publication number: WO 2022/077173

(56) References cited:
- CN-A- 106 773 389
- CN-A- 107 610 635
- CN-A- 110 491 918
- CN-A- 111 613 661
- JP-A- H01 120 075
- US-A1- 2019 363 153
- US-A1- 2020 273 944

## Description

### TECHNICAL FIELD

The present disclosure relates to the field of display technology, and in particular to a display panel, a method for manufacturing a display panel, and a display apparatus.

### BACKGROUND

At present, a display apparatus, such as a mobile phone, has more and more functions, and has higher and higher requirements on a screen-to-body ratio and other parameters of a display panel, so that traces in the display panel are designed to more and more complex, and the number of the traces is greater. Therefore, it is particularly important in the manufacturing of the display panel to provide a great number of traces in a limited space. US patent application US2019363153A1 discloses a display device including a TFT layer provided in a display area, a bending section and a terminal in a non-active area, and a terminal wiring line that connects to the terminal through the bending section, and the terminal wiring line includes a first wiring line and a second wiring line each positioned on both sides of the bending section and a third wiring line that passes through the bending section and is electrically connected with each of the first wiring line and the second wiring line and curved so as to have recesses and protrusions. US patent application US2020273944A1 discloses a display apparatus including: a substrate having a bending area between a first area and a second area; an inorganic insulating layer arranged on the substrate, the inorganic insulating layer having an opening or a groove corresponding to the bending area; a wiring unit extending to the second area through the bending area, the wiring unit arranged on the inorganic insulating layer and at least a portion thereof overlapping the opening or the groove; and an organic material layer between the inorganic insulating layer and the wiring unit, the organic material layer configured to fill the opening or the groove.

Therefore, research on the display panel should be well developed.

### SUMMARY

The present disclosure is directed to solving, at least in part, one of the technical problems in the related art. Therefore, an object of the present disclosure is to provide a display panel, where a distance between two adjacent traces is small, and more traces can be more reasonably arranged in a limited space, so as to meet the use requirements.

In one aspect of the present disclosure, the present disclosure provides a display panel. According to the invention, the display panel includes:
a base substrate; a first insulating layer on a side of the base substrate; wherein the first insulating layer includes a plurality of grooves and a plurality of protrusions on a side of the first insulating layer away from the base substrate and alternately arranged in sequence; each groove includes a side wall and a bottom surface, and each protrusion includes a top surface; and traces on the side of the first insulating layer away from the base substrate, wherein the traces include first traces and second traces, each first trace is on a side of the top surface of the corresponding protrusion away from the base substrate, each second trace is on the bottom surface of the corresponding groove, and the first traces are disconnected from the second traces. That is, the first traces are not connected to the second traces. Therefore, the first traces and the second traces are respectively arranged on the top surfaces of the protrusions and the bottom surfaces of the grooves of the first insulating layer; the first traces are disconnected from the second traces due to the existence of the step by providing the grooves. Compared with the case that the first traces and the second traces are arranged in the same plane (namely, the first insulating layer is not provided with the grooves, the first traces and the second traces are both arranged on the same flat surface of the first insulating layer), the horizontal distance between the first trace and the second trace adjacent to each other can be greatly reduced, and further, more number of the traces can be arranged in the same size range.

According to the invention, the display panel includes a first display region and a second display region at an outer edge of the first display region, wherein the display panel includes: a plurality of first pixel circuits between the base substrate and the first insulating layer and in the second display region; and light emitting devices on a side of the traces away from the base substrate and in the first display region, wherein each trace is used for electrically connecting the corresponding first pixel circuit and the corresponding light emitting device, so that the first pixel circuit drives the corresponding light emitting device to emit light.

According to an embodiment of the present disclosure, an angle between the side wall of each groove and a plane where the bottom surface of the groove is located is in a range from 65° to 90°, and a depth of each groove is in a range from 100 nm to 480 nm.

According to an embodiment of the present disclosure, a horizontal distance between the first trace and the second trace adjacent to each other is in a range from 1.8µm to 2.5 µm.

According to an embodiment of the present disclosure, the plurality of grooves do not penetrate through the first insulating layer, and a thickness of the first insulating layer at the bottom surface is in a range from 20 nm to 50 nm.

According to an embodiment of the present disclosure, the display panel further includes an under-screen functional region, and an orthographic projection of the first display region on the base substrate and an orthographic projection of the under-screen functional region on the base substrate has an overlapping region therebetween.

According to an embodiment of the present disclosure, the display panel further includes: a second insulating layer on a surface of the first insulating layer away from the base substrate and provided with through holes penetrating through the second insulating layer therein, wherein an orthographic projection of each through hole on the base substrate and an orthographic projection of the corresponding groove on the base substrate have an overlapping region therebetween, and the first traces are on a surface of the second insulating layer away from the base substrate.

According to an embodiment of the present disclosure, an angle between a side wall of each through hole and a plane where the second insulating layer is located is an obtuse angle.

According to an embodiment of the present disclosure, the second insulating layer has a thickness in a range from 150 nm to 500 nm.

According to an embodiment of the present disclosure, materials of the first insulating layer and the second insulating layer are different from each other.

According to an embodiment of the present disclosure, the material of the first insulating layer includes silicon nitride, and the material of the second insulating layer includes silicon oxide.

According to an embodiment of the present disclosure, the display panel further includes: a third insulating layer on a surface of the first insulating layer close to the base substrate, wherein an orthographic projection of the first insulating layer on the base substrate covers an orthographic projection of the third insulating layer on the base substrate, and there is a non-overlapping region between the orthographic projection of the third insulating layer on the base substrate and an orthographic projection of each groove on the base substrate.

According to an embodiment of the present disclosure, the display panel further includes: a fourth insulating layer on a surface of the first insulating layer close to the base substrate, wherein an orthographic projection of the fourth insulating layer on the base substrate covers an orthographic projection of each groove on the base substrate.

According to an embodiment of the present disclosure, the plurality of grooves penetrate through the first insulating layer, and the second traces are on a surface of the fourth insulating layer exposed by the plurality of grooves.

According to an embodiment of the present disclosure, the fourth insulating layer includes concave portions therein, an orthographic projection of each groove on the base substrate and an orthographic projection of the corresponding concave portion on the base substrate have an overlapping region therebetween; each second trace is on a bottom surface of the corresponding concave portion.

In another aspect of the present disclosure, the present disclosure provides a method for manufacturing a display panel. According to the invention, the method for manufacturing a display panel includes: providing a base substrate; forming a first original insulating layer on a side of the base substrate; etching the first original insulating layer, to obtain a first insulating layer including a plurality of grooves and a plurality of protrusions alternately arranged in sequence, wherein each groove includes a side wall and a bottom surface, and each protrusion includes a top surface; and forming traces on a side of the first insulating layer away from the base substrate, wherein the traces include first traces and second traces, each first trace is on a side of the top surface of the corresponding protrusion away from the base substrate, each second trace is on the bottom surface of the corresponding groove, and the first traces are disconnected from the second traces. Therefore, in the manufacturing method, the first traces and the second traces are respectively formed on the top surfaces of the protrusions and the bottom surfaces of the grooves of the first insulating layer; the first traces are disconnected from the second traces due to the existence of the step by providing the grooves. Compared with the case that the first traces and the second traces are arranged in the same plane (namely, the first insulating layer is not provided with the grooves, the first traces and the second traces are both arranged on the same flat surface of the first insulating layer), the horizontal distance between the first trace and the second trace adjacent to each other can be greatly reduced, and further, more number of the traces can be arranged in the same size range. Moreover, the manufacturing method is simple and mature, and is convenient for implementation and industrial mass production.

According to the invention, the display panel includes a first display region and a second display region disposed at an outer edge of the first display region, and wherein the method for manufacturing the display panel includes: forming a plurality of first pixel circuits on a surface of the base substrate and located in the second display region; forming the first insulating layer on a side of the plurality of first pixel circuits away from the base substrate; forming the traces on a side of the first insulating layer away from the base substrate; and forming light emitting devices on a side of the traces away from the base substrate and located in the first display region, wherein each trace is used for electrically connecting the corresponding first pixel circuit and the corresponding light emitting device, so that the first pixel circuit drives the corresponding light emitting device to emit light.

According to an embodiment of the present disclosure, the etching the first original insulating layer to obtain the first insulating layer includes: forming a whole photoresist layer on a surface of the first original insulating layer; performing an exposure process and a development process on a predetermined region of the whole photoresist layer, to obtain a photoresist layer having openings therein; and etching a part of the first original insulating layer exposed by the openings by using an etching gas, to obtain the first insulating layer, wherein an exposure amount in the exposure process is in a range from 100 mJ to 160 mJ, and a development time is in a range from 40s to 80s; and/or an etching rate in the etching process is in a range from 2500A/min to 3500A/min.

According to an embodiment of the present disclosure, the method includes: forming a second original insulating layer on a surface of the first original insulating layer away from the base substrate; forming a whole photoresist layer on a surface of the second original insulating layer; exposing and developing a predetermined region of the whole photoresist layer, to obtain a photoresist layer having openings therein; and etching the second original insulating layer and the first original insulating layer exposed by the openings by using an etching gas, to obtain the second insulating layer provided with the through holes therein and the first insulating layer provided with the plurality of grooves therein, wherein an orthographic projection of each through hole on the base substrate and an orthographic projection of the corresponding groove on the base substrate have an overlapping region therebetween, and the first traces are disposed on the surface of the second insulating layer away from the base substrate.

According to an embodiment of the present disclosure, prior to forming the first original insulating layer, the method further includes: forming a third original insulating layer; and etching the third original insulating layer, to obtain a patterned third insulating layer; wherein an orthographic projection of the first insulating layer on the base substrate covers an orthographic projection of the third insulating layer on the base substrate, and there is a non-overlapping region between the orthographic projection of the third insulating layer on the base substrate and an orthographic projection of each groove on the base substrate.

According to an embodiment of the present disclosure, the method further includes: forming a fourth original insulating layer before the first original insulating layer is formed, wherein the first original insulating layer is formed on a surface of the fourth original insulating layer away from the base substrate; and etching the first original insulating layer and the fourth original insulating layer, to obtain the first insulating layer provided with the plurality of grooves therein and the fourth insulating layer provided with the concave portions therein, wherein the plurality of grooves penetrate through the first insulating layer, an orthographic projection of each groove on the base substrate and an orthographic projection of the corresponding concave portion on the base substrate have an overlapping region therebetween, and each second trace is formed on a bottom surface of the corresponding concave portion.

In yet another aspect of the present disclosure, the present disclosure provides a display apparatus. According to an embodiment of the present disclosure, the display apparatus includes the display panel described above, including a first display region and a second display region; wherein the display panel includes an under-screen functional region, and an orthographic projection of the under-screen functional region on the display panel and an orthographic projection of the first display region on the display panel have an overlapping region therebetween. Therefore, a large-sized under-screen functional region can be designed in the display apparatus. It will be understood by one of ordinary skill in the art that the display apparatus has all the characteristics and advantages of the display panel described above, which will not be described herein in detail.

### BRIEF DESCRIPTION OF DRAWINGS

FIG. 1 is a schematic diagram of a structure of a display panel according to an embodiment of the present disclosure;
FIG. 2 is a schematic plan view of a display panel according to another embodiment of the present disclosure;
FIG. 3 is a schematic diagram illustrating a flat layout design of a display panel according to yet another embodiment of the present disclosure;
FIG. 4 is a schematic diagram illustrating a flat layout design of a display panel according to yet another embodiment of the present disclosure;
FIG. 5 is a schematic plan view of a display panel according to another embodiment of the present disclosure;
FIG. 6 is a schematic diagram of a structure of a display panel according to another embodiment of the present disclosure;
FIG. 7 is a schematic diagram of a structure of a display panel according to another embodiment of the present disclosure;
FIG. 8 is a schematic diagram of a structure of a display panel according to another embodiment of the present disclosure;
FIG. 9 is a schematic diagram of a structure of a display panel according to another embodiment of the present disclosure;
FIG. 10 is a schematic diagram of a structure of a display panel according to another embodiment of the present disclosure;
FIG. 11 is a schematic diagram of a structure of a display panel according to another embodiment of the present disclosure;
FIG. 12 is a schematic diagram of a structure of a display panel according to another embodiment of the present disclosure;
FIG. 13 is a schematic diagram of a structure of a display panel according to another embodiment of the present disclosure;
FIG. 14 is a schematic diagram of a structure of a display panel according to another embodiment of the present disclosure;
FIG. 15 is a schematic diagram of a structure of a display panel in one example;
FIG. 16 is a schematic diagram illustrating respective structures formed in a method for manufacturing a display panel according to yet another embodiment of the present disclosure;
FIG. 17 is a schematic diagram illustrating respective structures formed in a method for manufacturing a display panel according to yet another embodiment of the present disclosure;
FIG. 18 is a schematic diagram illustrating respective structures formed in a method for manufacturing a display panel according to yet another embodiment of the present disclosure;
FIG. 19 is a schematic diagram illustrating respective structures formed in a method for manufacturing a display panel according to yet another embodiment of the present disclosure;
FIG. 20 is a schematic diagram illustrating respective structures formed in a method for manufacturing a display panel according to yet another embodiment of the present disclosure;
FIG. 21 is a schematic diagram illustrating respective structures formed in a method for manufacturing a display panel according to yet another embodiment of the present disclosure; and
FIG. 22 is a schematic diagram of a structure of a display apparatus according to yet another embodiment of the present disclosure.

### DETAIL DESCRIPTION OF EMBODIMENTS

Embodiments of the present disclosure are described in detail below. The following described embodiments are illustrative and only used to explain the present disclosure, but are not to be construed as limiting the present disclosure. Particular techniques or conditions, which are not indicated in the embodiments, are performed according to techniques or conditions described in literatures in the art or according to the product specification.

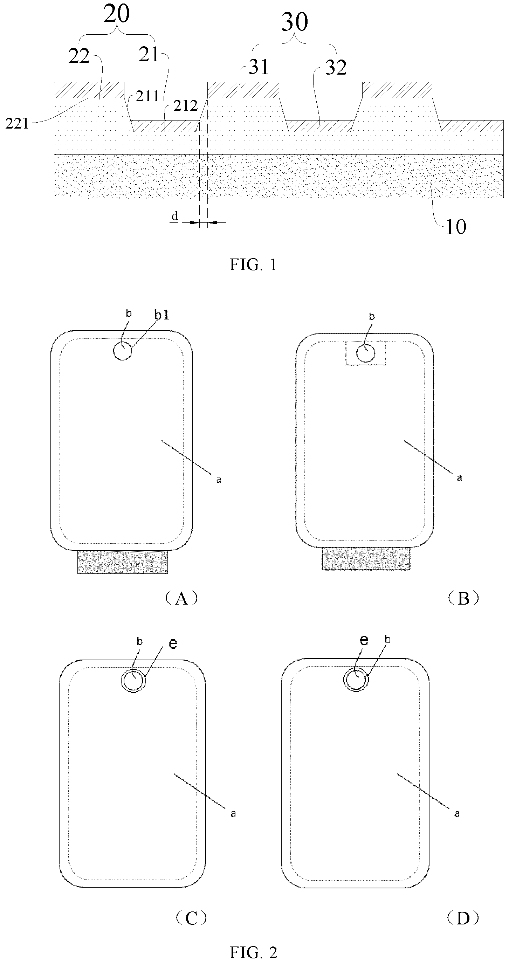

In one aspect of the present disclosure, referring to FIG. 1, the present disclosure provides a display panel. According to an embodiment of the present disclosure, the display panel includes: a base substrate 10; a first insulating layer 20 on a side of the base substrate 10; wherein the first insulating layer 20 includes a plurality of grooves 21 and a plurality of protrusions 22 on a side of the first insulating layer 20 away from the base substrate 10 and alternately arranged in sequence; each groove includes a side wall 211 and a bottom surface 212, and each protrusion includes a top surface 221 (as shown in FIG. 1, each side wall is connected to the bottom surface and the top surface); traces 30 disposed on a side of the first insulating layer 20 away from the base substrate 10, where the traces 30 include first traces 31 and second traces 32, each first trace 31 is disposed on a side of the top surface 221 of the corresponding protrusion 22 of the first insulating layer 20 away from the base substrate, each second trace 32 is disposed on the bottom surface 212 of the corresponding groove 21, and the first traces 31 are disconnected from the second traces 32. That is, the first traces 31 are not connected to the second traces 32. Therefore, the first traces 31 and the second traces 32 are respectively arranged on the top surfaces 221 of the protrusions 22 and the bottom surfaces 212 of the grooves 21 of the first insulating layer 20; the first traces 31 are disconnected from the second traces 32 due to the existence of the steps by providing the grooves 21. Compared with the case that the first traces and the second traces are arranged at a same level (namely, the first insulating layer is not provided with the grooves, the first traces and the second traces are both arranged on a same flat surface of the first insulating layer; in this case, in order to ensure that the first traces are completely disconnected from the second traces, a distance between a first trace and a second trace adjacent to each other is usually in a range from 3.5 to 4 micrometers), the horizontal distance d between the first trace 31 and the second trace 32 adjacent to each other can be greatly reduced, and further, more number of the traces can be arranged in the same size range.

It should be noted that, in the manufacturing procedure, the first traces and the second traces are formed simultaneously through a same deposition process, so that the traces are disconnected from each other due to the steps between the top surfaces 221 of the protrusions and the bottom surfaces 212 of the first insulating layer 20 in the deposition process, and thus the first traces and the second traces disconnected from each other are formed on the top surfaces 221 of the protrusions and the bottom surfaces 212, respectively. In addition, the horizontal distance d between the first trace 31 and the second trace 32 refers to a horizontal distance between the first trace and second trace adjacent to each other, specifically, between one end of the first trace close to the second trace and one end of the second trace close to the first trace.

Furthermore, a material of the trace 30 includes, but is not limited to, a transparent conductive material such as ITO, AZO, or the like, so that the light transmittance thereof is better, which is helpful for improving the light transmittance of the display panel.

According to an embodiment of the present disclosure, referring to FIG. 2, the display panel includes a first display region b and a second display region a disposed at an outer edge b1 of the first display region b. The second display region a is disposed at the outer edge of the first display region b, i.e., the second display region a is disposed outside the first display region b, or the second display region a is disposed at a periphery of the first display region b. In addition, there is no special requirement for the specific position of the first display region b, which can be freely selected by one of ordinary skill in the art according to an actual design requirement of an under-screen functional region. For example, the second display region may be located at a center of the display panel, or at a corner of the display panel, or may be located and centered on a side of the display panel close to a frame as shown in FIG. 2.

According to the embodiment of the present disclosure, as shown in parts (C) and (D) of FIG. 2, an orthographic projection of the first display region b on the base substrate and an orthographic projection of an under-screen functional region e on the base substrate have an overlapping region therebetween. In some embodiments, the orthographic projection of the first display region b on the base substrate overlaps with the orthographic projection of the under-screen functional region e on the base substrate; in other embodiments, the orthographic projection of the first display region b on the base substrate is covered by the orthographic projection of the under-screen functional region e on the base substrate, as shown in the part (C) of FIG. 2; in still other embodiments, the orthographic projection of the under-screen functional region e on the base substrate is covered by the orthographic projection of the first display region b on the base substrate, as shown in the part (D) of FIG. 2.

There is no special requirement for a longitudinal position of the under-screen functional region, which can be freely selected by one of ordinary skill in the art according to an actual design requirement. In some embodiments, the under-screen functional region may be disposed on a side of the display panel away from the screen. The under-screen functional region may be provided with an under-screen functional layer structure therein, wherein there is no special requirement for the specific structure of the under-screen functional layer structure, which can be freely selected by one of ordinary skill in the art according to an actual design requirement. In some embodiments, an under-screen camera is provided in the under-screen functional region. The above structure of the display panel of the present disclosure can meet the requirement of the under-screen camera for the high light transmittance and can realize the design requirement of the large-sized under-screen camera.

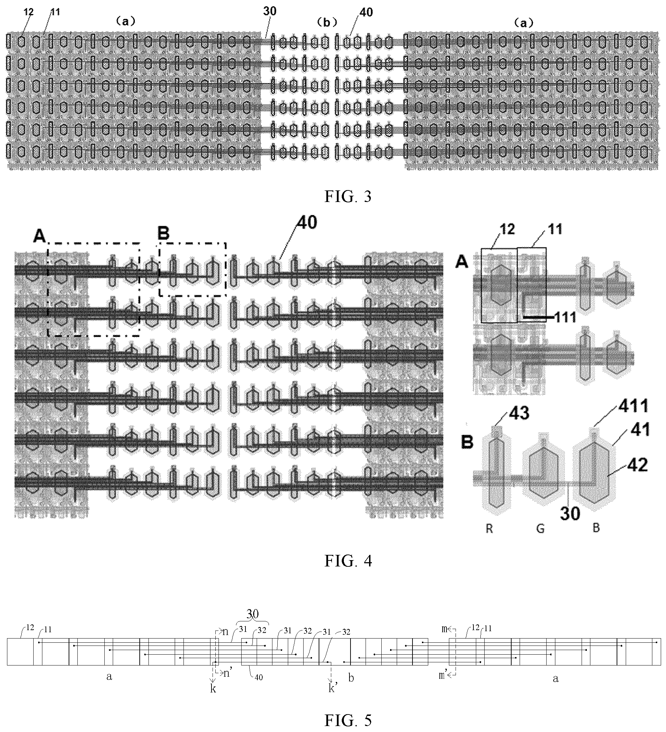

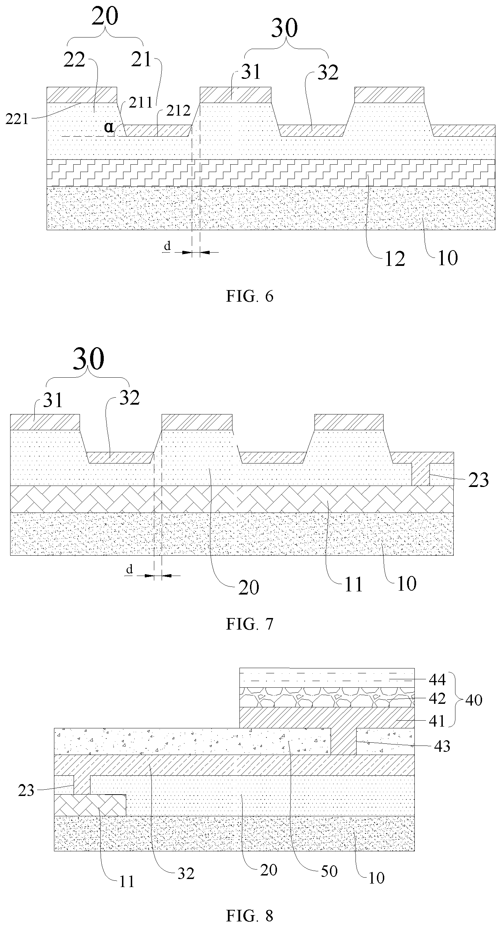

Further, referring to FIGS. 3 to 7 (FIG. 5 is a schematic diagram showing only a structure of one row of pixels, FIG. 6 is a cross-sectional view taken along a line m-m' of FIG. 5, and FIG. 7 is a cross-sectional view taken along a line n-n' of FIG. 5), the display panel includes: a base substrate 10; a plurality of first pixel circuits 11 disposed between the base substrate 10 and the first insulating layer 20 and in the second display region a; and light emitting devices 40 disposed on a side of the traces 30 away from the base substrate 10 and located in the first display region b, wherein each trace 30 is used for electrically connecting the corresponding first pixel circuit 11 and the corresponding light emitting device 40, so that the first pixel circuit 11 drives the corresponding light emitting device 40 to emit light. Thus, since the horizontal distance d between the first trace 31 and the second trace 32 is small, a large number of first traces 31 and second traces 32 can be disposed on the surface of the first insulating layer within a certain size range, and a large number of light emitting devices 40 can be disposed in the first display region b, so as to meet the design requirement of the large-sized under-screen functional region. It should be noted that, each first trace or each second trace is electrically connected to the corresponding first pixel circuit and the corresponding light emitting device, respectively. There is no special requirement for the specific structure of the light emitting device in the present disclosure, which can be freely selected by one of ordinary skill in the art according to an actual design requirement. According to an embodiment of the present disclosure, a light emitting device may include an anode, a hole injection layer, a hole transport layer, an electron blocking layer, a light emitting layer, a hole blocking layer, an electron transport layer, an electron injection layer, and a cathode.

In addition, there is no special requirement for the specific position of the first pixel circuit, which can be freely selected by one of ordinary skill in the art according to design requirements for the pixel. In some embodiments, the first pixel circuits 11 may be disposed only in a partial region of the second display region a close to the first display region b, rather than being distributed in the entire second display region a, as in the rectangular block in the right drawing of FIG. 2, i.e., the first pixel circuits are distributed only in the rectangular block in the second display region a.

Also, as shown in FIGS. 3, 4 and 5, the second display region a is further provided with second pixel circuits 12 therein, and there is no particular requirement for a specific relative position between the first pixel circuits and the second pixel circuits. Each first pixel circuit 11 may be disposed between two different second pixel circuits 12. One or more second pixel circuits may be disposed between two adjacent first pixel circuits, that is, the first pixel circuits 11 may not be disposed adjacently in the same row of the plurality of pixel circuits. In some embodiments, at least one second pixel circuit 12 is disposed between two adjacent first pixel circuits 11 in the same row of the plurality of pixel circuits. In some embodiments, in the same row of the plurality of pixel circuits, as shown in FIG. 5, one first pixel circuit 11 is disposed every other second pixel circuit 12; in other embodiments, as shown in FIGS. 3 and 4, one first pixel circuit 11 is provided every three second pixel circuits 12; in addition, in some embodiments, no second pixel circuit 12 may be provided between any two adjacent first pixel circuits 11, i.e., the first pixel circuits 11 may be disposed adjacently.

There is no special requirement for the specific structure of the first pixel circuit 11, which can be freely selected by one of ordinary skill in the art according to an actual requirement. In some embodiments, each first pixel circuit 11 is a 7T1C circuit (i.e., seven transistors and one capacitor) structure. For example, each first pixel circuit 11 includes a driving transistor, a data writing transistor, a storage capacitor, a threshold compensation transistor, a first reset transistor, a second reset transistor, a first light emitting control transistor, and a second light emitting control transistor; there is no particular requirement for the longitudinal structure of the first pixel circuit 11. In some embodiments, each first pixel circuit 11 includes an active layer, a gate insulating layer, a gate electrode, an interlayer dielectric layer, a source electrode, a drain electrode, a storage capacitor, and the like. In some embodiments, the trace 30 is electrically connected to a drain electrode 111 of a driving transistor (as shown in FIG. 4) through a via 23 (as shown in FIGS. 7 and 8, wherein FIG. 8 is a cross-sectional view taken along a line k-k' in FIG. 5), and no light emitting device is disposed in a pixel unit corresponding to the first pixel circuit 11, and the first pixel circuit 11 is only used for driving the light emitting device 40 in the first display region to emit light. The light emitting device in the first display region b is driven by the first pixel circuit 11 in the second display region to emit light without providing a pixel circuit in the first display region, so that the light transmittance in the first display region can be greatly improved, and the requirement of the under-screen functional region on high light transmittance is met.

In FIGS. 4 and 8, the right drawing in FIG. 4 represents an enlarged view of the dashed line block A and the dashed line block A in the left drawing of FIG. 4; the trace 30 is electrically connected to an anode 41 of the light emitting device 40 through a via 43, and an orthographic projection of the anode 41 on the base substrate covers an orthographic projection of an opening 42 defined by a pixel defining layer on the base substrate. In some embodiments, the anode 41 has a protrusion portion 411, and the trace 30 is electrically connected to the protrusion portion 411 of the anode 41 of the light emitting device 40 through the via 43.

In order to isolate the trace 30 from the anode 41, an insulating dielectric layer may be disposed between the trace 30 and the anode 41. In some embodiments, an insulating dielectric layer 50 is disposed between the trace 30 and the light emitting device, and the anode 43 is electrically connected to the trace 30 (shown in FIG. 8 as second trace 32) through a via 43 extending through the insulating dielectric layer 50.

According to the embodiment of the present disclosure, as shown in FIG. 6, an angle α between the side wall 211 of each groove 21 and a plane where the bottom surface 212 of the groove 21 is located is in a range from 65° to 90°. For example, the angle α is 65°, 68°, 70°, 72°, 75°, 78°, 80°, 82°, 85°, 88° or 90°; a depth of the groove is in a range from 100 nm to 480 nm. For example, the depth is 100 nm, 120 nm, 130 nm, 150 nm, 180 nm, 200 nm, 230 nm, 250 nm, 280 nm, 300 nm, 320 nm, 350 nm, 380 nm, 400 nm, 420 nm, 450 nm, or 480 nm. Therefore, the limitation of the angle and the depth of each groove can better ensure that the first traces are disconnected from the second traces due to the step between the top surfaces 221 of the protrusions and the bottom surfaces 212 of the grooves; if α is less than 65°, the side wall 211 of the groove 21 is relatively gentle, so that it is relatively not easy to completely disconnect the first traces 31 and the second traces 32 from each other, which may affect the normal light emission of a part of the light emitting devices in the first display region; if α is less than 65°, even if the first traces and the second traces may be disconnected from each other, the side wall 211 is relatively gentle, and the width of the side wall 211 is relatively wide, which is not beneficial to shortening the horizontal distance d between the first trace and the second trace.

It should be noted that the depth of the groove refers to a vertical distance between the top surface of the protrusion and the bottom surface of the groove.

Further, each groove 21 does not penetrate through the first insulating layer 20, and a thickness of the first insulating layer 20 at the bottom surface 212 is in a range from 20 nm to 50 nm (for example, 20 nm, 23 nm, 25 nm, 28 nm, 30 nm, 33 nm, 35 nm, 38 nm, 40 nm, 43 nm, 45 nm, 48 nm, or 50 nm). Therefore, the step between the top surface of the protrusion and the bottom surface of the groove is large, which can effectively ensure that the first traces and the second traces are completely disconnected from each other in the procedure for forming the first traces and the second traces through a deposition process due to the existence of the step.

According to the embodiment of the present disclosure, as shown in FIGS. 1, 6 and 7, the horizontal distance d between the first trace 31 and the second trace 32 is in a range from 1.8 micrometers to 2.5 micrometers, such as 1.8 micrometers, 1.9 micrometers, 2.0 micrometers, 2.1 micrometers, 2.2 micrometers, 2.3 micrometers, 2.4 micrometers or 2.5 micrometers. Therefore, the horizontal distance between the first trace and the second trace is small, and therefore a more number of traces can be arranged in a certain size range. Therefore, when the first display region is provided with a more number of light-emitting devices therein, the first traces and the second traces can still be reasonably arranged in a certain space. In other words, a more number of light-emitting devices 40 can be arranged in the first display region b, and the design requirement of the large-sized under-screen functional layer is met.

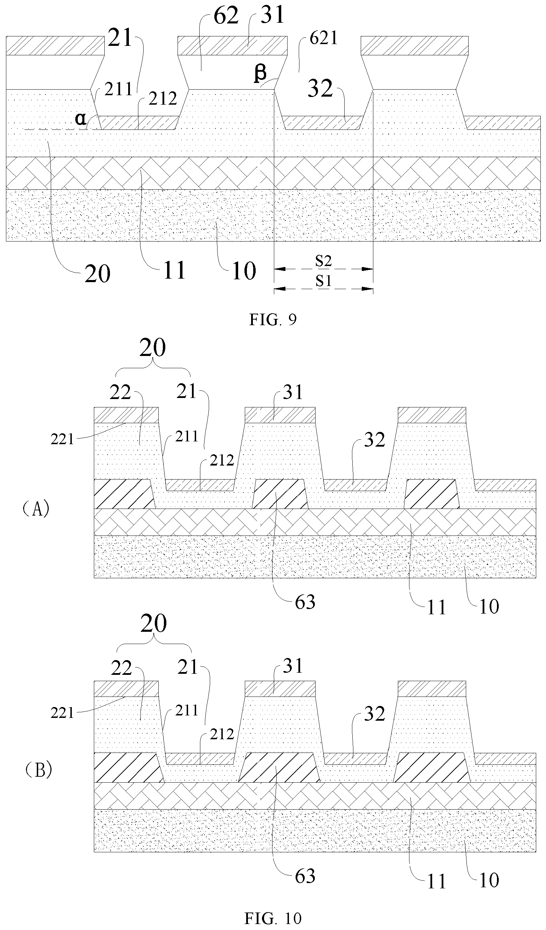

According to an embodiment of the present disclosure, referring to FIG. 9, the display panel further includes: a second insulating layer 62 on a surface of the first insulating layer 20 away from the base substrate 10; the first traces 31 are disposed on a surface of the second insulating layer 62 away from the base substrate 10, and the second insulating layer 62 is provided with through holes 621 penetrating through the second insulating layer 62 therein, and an orthographic projection S1 of each through hole 621 on the base substrate 10 and an orthographic projection S2 of the corresponding groove 21 on the base substrate 10 have an overlapping region therebetween, and the first traces are disposed on the surface of the second insulating layer away from the base substrate. Therefore, the step between the first trace 31 and the second trace 32 can have a further increased height by providing the second insulating layer, so that the first trace 31 and the second trace 32 can be more easily disconnected from each other, and the risk of connection between the first trace 31 and the second trace 32 can be further reduced. Further, as shown in FIG. 9, the orthographic projection S1 of each through hole 621 on the base substrate 10 completely overlaps with the orthographic projection S2 of the corresponding groove 21 on the base substrate 10.

According to the embodiment of the present disclosure, an angle β between the side wall of each through hole 621 and a plane where the second insulating layer is located is an obtuse angle (i.e., an angle β between the side wall of the through hole 621 and a bottom surface of the second insulating layer is an obtuse angle β). Therefore, the second insulating layer obtained by an etching process has a shape of an inverted trapezoid, which is more beneficial to making the first trace and the second trace disconnected from each other.

According to an embodiment of the present disclosure, the second insulating layer has a thickness in a range from 150 nm to 500 nm, such as 150 nm, 180 nm, 200 nm, 230 nm, 250 nm, 280 nm, 300 nm, 320 nm, 350 nm, 380 nm, 400 nm, 420 nm, 450 nm, 480 nm, or 500 nm. Therefore, with the second insulating layer having the above thickness, it can ensure that the first traces and the second traces are easily disconnected from each other in the procedure for forming the first traces and the second traces through a deposition process, and can avoid that an inconvenient subsequent encapsulation of the display panel is caused by the second insulating layer with a greater thickness. It should be noted that, the thickness of the second insulating layer refers to a distance between a surface of the second insulating layer away from the base substrate and a surface of the second insulating layer close to the base substrate.

According to the embodiment of the present disclosure, the materials of the first insulating layer and the second insulating layer are different from each other, so that the obtained angles α and β are different from each other, which is more beneficial to disconnecting the first traces from the second traces. In some embodiments, the first insulating layer and the second insulating layer include silicon nitride, silicon oxide, or silicon oxynitride, respectively. These materials have good insulating properties, and the first insulating layer and the second insulating layer made of these materials have good properties, so as to meet various requirements of the insulating layer in the display panel.

In some embodiments, the material of the first insulating layer includes silicon nitride and the material of the second insulating layer includes silicon oxide. Thus, α and β having desired angular magnitudes can be obtained efficiently.

According to an embodiment of the present disclosure, referring to FIG. 10, the display panel further includes: a third insulating layer 63 disposed on a surface of the first insulating layer 20 close to the base substrate 10, an orthographic projection of the first insulating layer 20 on the base substrate 10 covers an orthographic projection of the third insulating layer 63 on the base substrate 10, and there is a non-overlapping region between the orthographic projection of the third insulating layer 63 on the base substrate 10 and an orthographic projection of the groove 21 on the base substrate 10 (that is, there is no overlapping between the orthographic projection of the third insulating layer 63 on the base substrate 10 and an orthographic projection of the groove 21 on the base substrate 10). Therefore, by providing the third insulating layer, the step between the top surface 221 of the protrusion 22 and the bottom surface 212 of the groove 21 of the first insulating layer 20, that is, the step between the first trace and the second trace, can be further increased (can have a larger height), so that when the traces are formed by a deposition process, the first traces and the second traces can be more easily and completely disconnected from each other. In some embodiments, as shown in a part (A) of FIG. 10, the non-overlapping region between the orthographic projection of the third insulating layer 63 on the base substrate 10 and the orthographic projection of the groove 21 on the base substrate 10 is a completely non-overlapping region; in other embodiments, as shown in a part (B) of FIG. 10, the region between the orthographic projection of the third insulating layer 63 on the base substrate 10 and the orthographic projection of the groove 21 on the base substrate 10 includes the non-overlapping region and the partially overlapping region

According to an embodiment of the present disclosure, the third insulating layer 63 has a thickness in a range from 1000 nm to 2500 nm, such as 1000 nm, 1100 nm, 1200 nm, 1300 nm, 1400 nm, 1500 nm, 1600 nm, 1700 nm, 1800 nm, 1900 nm, 2000 nm, 2100 nm, 2200 nm, 2300 nm, 2400 nm, or 2500 nm. Therefore, the step between the top surface 221 of the protrusion 22 and the bottom surface 212 of the groove 21 of the first insulating layer 20 can be effectively increased, it is ensured that the first traces and the second traces can be disconnected from each other more easily and completely, and the product yield is improved. It should be noted that the thickness of the third insulating layer refers to a distance between a surface of the third insulating layer away from the base substrate and a surface of the third insulating layer close to the base substrate.

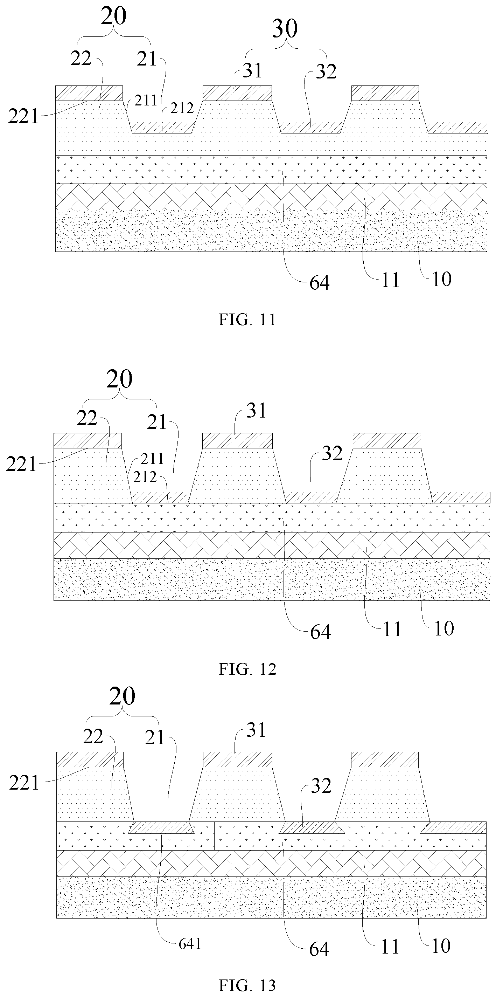

According to an embodiment of the present disclosure, referring to FIG. 11, the display panel further includes: a fourth insulating layer 64 disposed on a surface of the first insulating layer 20 close to the base substrate 10, and an orthographic projection of the fourth insulating layer 64 on the base substrate 10 covers the orthographic projection of the groove 21 on the base substrate. Therefore, the disconnection between the first traces and the second traces can still be effectively realized.

According to an embodiment of the present disclosure, referring to FIG. 12, the grooves 21 penetrate through the first insulating layer 20, and the second traces 32 are disposed on a surface of the fourth insulating layer 64 exposed by the grooves 21. Therefore, the grooves penetrate through the first insulating layer, so that the step between the first trace 31 and the second trace 32 can be further increased, the first trace and the second trace can be better ensured to be completely and thoroughly disconnected from each other, and the product yield is further improved.

According to an embodiment of the present disclosure, referring to FIG. 13, the fourth insulating layer 64 is provided with concave portions 641 therein, an orthographic projection of each groove 21 on the base substrate 10 and an orthographic projection of the corresponding concave portion 641 on the base substrate 10 have an overlapping region therebetween; each second trace 32 is formed on a bottom surface of the corresponding concave portion 641. Thus, by providing the concave portions 641, the step between the first trace 31 and the second trace 32 can be further increased, the first trace and the second trace can be better ensured to be completely and thoroughly disconnected from each other, and the product yield is further improved. There is no special relationship between a depth of the concave portion and the thickness of the second trace, which can be freely selected by one of ordinary skill in the art according to a design requirement, such as the step between the first trace and the second trace. For example, the depth of the concave portion is greater than the thickness of the second trace, or the depth of the concave portion is less than the thickness of the second trace, or the depth of the concave portion is equal to the thickness of the second trace (as an example, in FIG. 13, the depth of the concave portion is equal to the thickness of the second trace).

According to an embodiment of the present disclosure, a maximum thickness of the fourth insulating layer is in a range from 1000 nm to 2500 nm, such as 1000 nm, 1100 nm, 1200 nm, 1300 nm, 1400 nm, 1500 nm, 1600 nm, 1700 nm, 1800 nm, 1900 nm, 2000 nm, 2100 nm, 2200 nm, 2300 nm, 2400 nm, or 2500 nm. It should be noted that the maximum thickness of the fourth insulating layer, which is in a range from 1000 nm to 2500 nm, is a thickness of the fourth insulating layer at a position except the concave portion. It should be noted that the thickness of the fourth insulating layer refers to a distance between a surface of the fourth insulating layer at a position except the concave portion away from the base substrate and a surface of the fourth insulating layer close to the base substrate.

Furthermore, there is no special requirement for the material of each of the third insulating layer and the fourth insulating layer, as long as the material of each of the third insulating layer and the fourth insulating layer has good insulating property, which can be freely selected by a person skilled in the art according to actual conditions. In some embodiments, the materials of the third insulating layer and the fourth insulating layer each include, but are not limited to, an inorganic material such as silicon nitride, silicon oxide, or silicon oxynitride, and an organic material such as PR glue.

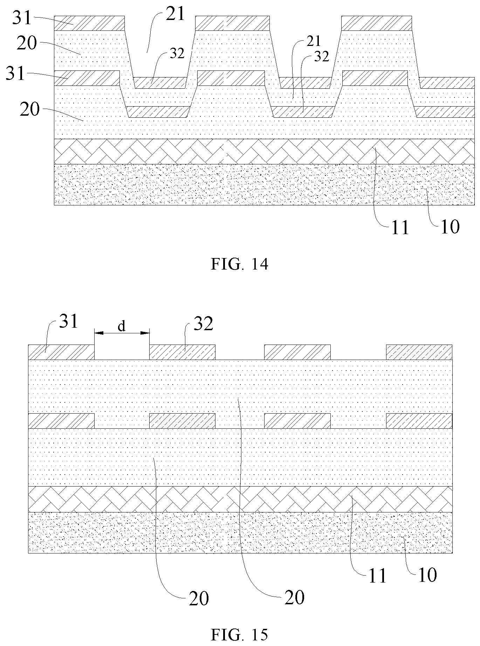

According to the embodiment of the present disclosure, if a size of the first display region is larger (that is, there are more light emitting devices arranged in the first display region), and the number of the plurality of first traces 31 and the plurality of second traces 32 disposed only on the side of the single first insulating layer 20 away from the base substrate still cannot satisfy that the plurality of first traces 31 and the plurality of second traces 32 are electrically connected to all the light emitting devices in the first display region one by one, two first insulating layers 20 stacked together may be disposed. As shown in FIG. 14, each first insulating layer 20 is provided with the grooves 21 therein, and the first traces 31 and the second traces 32 are disposed on both the top surfaces of the protrusions and the bottom surfaces of the grooves of each first insulating layer 20. Similarly, if the number of the traces is further increased, a person skilled in the art may provide three or four or more first insulating layers to provide the more number of traces.

According to the embodiment of the present disclosure, for the first display region with the same size, and the light emitting devices with the same number in the first display region and the first traces and the second traces with the same number, in the technical solution of the present disclosure, only N (N is an integer greater than or equal to 1) first insulating layers 20 are required to be provided for a reasonable layout of the plurality of first traces and the plurality of second traces therein. However, if the first traces and the second traces are disposed on the flat surface of the insulating layer without the grooves, in order to ensure that the first traces and the second traces are effectively disconnected from each other, the horizontal distance between the first trace and the second trace adjacent to each other is in a range from about 3.5 to 4 micrometers, and thus the number of the first traces and the number of the second traces disposed on the surface of each insulating layer are less than that in the technical solution of the present disclosure (as shown in FIGS. 6 and 15, in the trace arrangement space with the same size, six traces may be arranged in FIG. 6, and only four traces may be arranged in FIG. 15). If the first traces and the second traces with the same number are to be arranged, at least (N+1) stacked insulating layers may be disposed, so that the first traces and the second traces are dispersedly disposed on the surfaces of the (N+1) insulating layers (as shown in FIG. 15). However, such a technical solution may increase the overall thickness of the display panel, a height of an encapsulating dam is increased, which is not favorable to encapsulating the display panel, and such a technical solution may additionally introduce a mask process, thereby increasing the manufacturing cost.

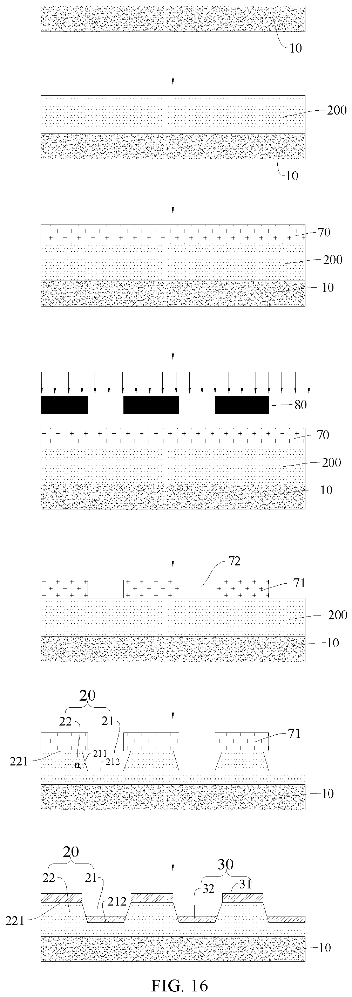

In another aspect of the present disclosure, the present disclosure provides a method for manufacturing a display panel. According to an embodiment of the present disclosure, as shown in FIG. 16, the method for manufacturing a display panel includes:
S100: providing a base substrate 10.
S200: forming a first original insulating layer 200 on a side of the base substrate 10.
S300: etching the first original insulating layer 200 to obtain a first insulating layer 20 including a plurality of grooves and a plurality of protrusions alternately arranged in sequence, such that each groove 21 includes a side wall 211 and a bottom surface 212, and each protrusion includes a top surface 221.

The etching the first original insulating layer to obtain the first insulating layer 20, includes:
S310: forming a whole photoresist layer 70 on a surface of the first original insulating layer;
S320: exposing and developing a predetermined region of the whole photoresist layer 70, to obtain a photoresist layer 71 having openings 72 therein;
S330: etching a part of the first original insulating layer 200 exposed by the openings 72 by using an etching gas, to obtain a first insulating layer 20, wherein the exposure amount in the exposure process is in a range from 100 mJ to 160 mJ, and the development time is in a range from 40s to 80s; and/or the etching rate in the etching process is in a range from 2500A/min to 3500A/min. With the above exposure amount, the development time and the etching rate, an angle α between the side wall 211 of each groove 21 and a plane where the bottom surface 212 of the groove 21 is located is in a range from 65° to 90°; and a depth of the groove is in a range from 100 nm to 480 nm, which can better ensure that the first traces and the second traces subsequently formed through a deposition process are disconnected from each other due to the step between the top surfaces 221 of the protrusions and the bottom surfaces 212 of the grooves; if α is less than 65°, the side wall 211 of the groove 21 is relatively gentle, so that it is relatively not easy to completely disconnect the first traces 31 and the second traces 32 from each other, which may affect the normal light emission of a part of the light emitting devices in the first display region; if α is less than 65°, even if the first traces and the second traces may be disconnected from each other, the side wall 211 is relatively gentle, and the width of the side wall 211 is relatively wide, which is not beneficial to shortening the horizontal distance d between the first trace and the second trace.
S400: forming the traces 30 on a side of the first insulating layer 20 away from the base substrate 10, wherein the traces 30 include first traces 31 and second traces 32; each first trace 31 is disposed on the top surface 221 of the corresponding protrusion 22 of the first insulating layer 20, each second trace 32 is disposed on the bottom surface 212 of the corresponding groove 21. The first traces and the second traces are formed simultaneously through the same deposition process. The first traces and the second traces are formed simultaneously through the same deposition process, so that the traces are disconnected from each other due to the steps between the top surfaces 221 of the protrusions 22 and the bottom surfaces 212 of the grooves of the first insulating layer 20 in the deposition process, and thus the first traces and the second traces disconnected from each other are formed on the top surfaces 221 of the protrusions 22 and the bottom surfaces 212 of the grooves, respectively.

Therefore, in the manufacturing method, the first traces and the second traces are respectively formed on the top surfaces of the protrusions (or the top surface of the first insulating layer) and in the grooves of the first insulating layer; the first traces are disconnected from the second traces due to the existence of the steps by providing the grooves. Compared with the case that the first traces and the second traces are arranged at a same level (in the same plane) (namely, the first insulating layer is not provided with the grooves, the first traces and the second traces are both arranged on the same flat surface of the first insulating layer), the horizontal distance between the first trace and the second trace adjacent to each other can be greatly reduced, and further, more number of the traces can be arranged in the same size range. Moreover, the manufacturing method is simple and mature, and is convenient for implementation and industrial mass production.

According to the embodiment of the present disclosure, the display panel includes a first display region b and a second display region a disposed at an outer edge of the first display region b. An orthographic projection of the first display region b on the base substrate 10 and an orthographic projection of an under-screen functional region on the base substrate 10 have an overlapping region therebetween. The method for manufacturing the display panel includes:
Forming a plurality of first pixel circuits 11 on a surface of the base substrate 10 and located in the second display region a; forming the first insulating layer 20 on a side of the plurality of first pixel circuits 11 away from the base substrate 10; forming the traces 30 on a surface of the first insulating layer 20 away from the base substrate 10; forming light emitting devices 40 on a side of the traces 30 away from the base substrate 10 and located in the first display region b, wherein each trace 30 is used for electrically connecting the corresponding first pixel circuit 11 and the corresponding light emitting device 40, so that the first pixel circuit 11 drives the corresponding light emitting device 40 to emit light, as shown in FIGS. 2 to 8 which are the schematic diagrams of the structure. Thus, since the horizontal distance d between the first trace 31 and the second trace 32 is small, a large number of first traces 31 and second traces 32 can be disposed on the surface of the first insulating layer within a certain size range, and a large number of light emitting devices 40 can be disposed in the first display region b, so as to meet the design requirement of the large-sized under-screen functional region. It should be noted that each first trace or each second trace is electrically connected to the corresponding first pixel circuit and the corresponding light emitting device, respectively.

In addition, there is no special requirement for the specific position of the first pixel circuit, which can be freely selected by one of ordinary skill in the art according to a design requirement for the pixel. In some embodiments, the first pixel circuits 11 may be disposed only in a partial region of the second display region a close to the first display region b, rather than being distributed in the entire second display region a, as in the rectangular block in the right drawing of FIG. 2, i.e., the first pixel circuits are distributed only in the rectangular block in the second display region a.

Also, as shown in FIGS. 3, 4 and 5, the second display region a is further provided with second pixel circuits 12 therein, and there is no particular requirement for a specific relative position between the first pixel circuits and the second pixel circuits. Each first pixel circuit 11 may be disposed between two different second pixel circuits 12. One or more second pixel circuits may be disposed between two adjacent first pixel circuits, that is, the first pixel circuits 11 may not be disposed adjacently in the same row of the plurality of pixel circuits. That is, at least one second pixel circuit 12 is disposed between two adjacent first pixel circuits 11 in the same row of the plurality of pixel circuits. In some embodiments, in the same row of the plurality of pixel circuits, as shown in FIG. 5, one first pixel circuit 11 is disposed every other second pixel circuit 12; in other embodiments, as shown in FIGS. 3 and 4, one first pixel circuit 11 is provided every three second pixel circuits 12; in addition, in some embodiments, no second pixel circuit 12 may be provided between any two adjacent first pixel circuits 11, i.e., the first pixel circuits 11 may be disposed adjacently.

There is no special requirement for the specific structure of the first pixel circuit 11, which can be freely selected by one of ordinary skill in the art according to an actual requirement. In some embodiments, each first pixel circuit 11 is a 7T1C circuit (i.e., seven transistors and one capacitor) structure. For example, each first pixel circuit 11 includes a driving transistor, a data writing transistor, a storage capacitor, a threshold compensation transistor, a first reset transistor, a second reset transistor, a first light emitting control transistor, and a second light emitting control transistor; there is no particular requirement for the longitudinal structure of the first pixel circuit 11. In some embodiments, each first pixel circuit 11 includes an active layer, a gate insulating layer, a gate electrode, an interlayer dielectric layer, a source electrode, a drain electrode, a storage capacitor, and the like. The trace 30 is electrically connected to a drain electrode 111 of a driving transistor (as shown in FIG. 4) through a via 23 (as shown in FIGS. 7 and 8, wherein FIG. 8 is a cross-sectional view taken along a line k-k' in FIG. 5), and no light emitting device is disposed in a pixel unit corresponding to the first pixel circuit 11, and the first pixel circuit 11 is only used for driving the light emitting device 40 in the first display region b to emit light. The light emitting device in the first display region b is driven by the first pixel circuit 11 in the second display region a to emit light without providing a pixel circuit in the first display region, so that the light transmittance in the first display region can be greatly improved, and the requirement of the under-screen functional region on a high light transmittance is met.

In FIGS. 4 and 8, the right drawing in FIG. 4 represents an enlarged view of the dashed line block A and an enlarged view of the dashed line block B in the left drawing of FIG. 4, respectively; the trace 30 is electrically connected to an anode 41 of the light emitting device 40 through a via 43, and an orthographic projection of the anode 41 on the base substrate covers an orthographic projection of an opening 42 defined by a pixel defining layer on the base substrate. In some embodiments, the anode 41 has a protrusion portion 411, and the trace 30 is electrically connected to the protrusion portion 411 of the anode 41 of the light emitting device 40 through the via 43.

In order to isolate the trace 30 from the anode 41, an insulating dielectric layer 50 may be disposed between the trace 30 and the anode 41. In some embodiments, an insulating dielectric layer 50 is disposed between the trace 30 and the light emitting device, and the anode 41 is electrically connected to the trace 30 (the second trace 32 shown in FIG. 8) through the via 43 extending through the insulating dielectric layer 50.

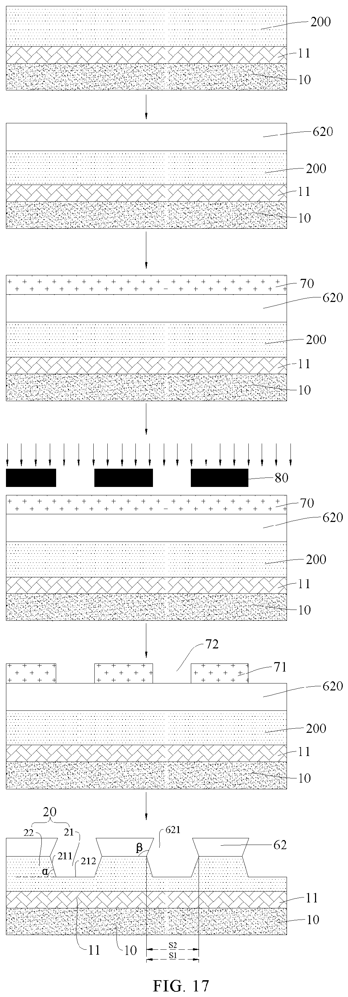

According to an embodiment of the present disclosure, referring to FIG. 17, a method for manufacturing a display panel includes:
S510: forming a second original insulating layer 620 on a surface of the first original insulating layer 200 away from the base substrate;
S520: forming a whole photoresist layer 70 on a surface of the second original insulating layer 620;
S530: exposing and developing a predetermined region of the whole photoresist layer 70, to obtain a photoresist layer 71 having openings 72 therein;
S540: etching the second original insulating layer 620 and the first original insulating layer 200 exposed by the openings 72 by using an etching gas, to obtain the second insulating layer 62 provided with the through holes 621 therein and the first insulating layer 20 provided with the grooves 21 therein, wherein an orthographic projection S1 of each through hole 621 on the base substrate 10 and an orthographic projection S2 of the corresponding groove 21 on the base substrate 10 have an overlapping region therebetween, and the first traces 31 are disposed on the surface of the second insulating layer 62 away from the base substrate 10. Therefore, the step between the first trace 31 and the second trace 32 can be further increased by providing the second insulating layer, so that the first trace 31 and the second trace 32 can be more easily disconnected from each other, and the risk of connection between the first trace 31 and the second trace 32 can be further reduced. Further, as shown in FIG. 9, the orthographic projection S1 of each through hole 621 on the base substrate 10 completely overlaps with the orthographic projection S2 of the corresponding groove 21 on the base substrate 10.

Further, an angle β between the side wall of each through hole 621 and a plane where the second insulating layer is located is an obtuse angle. Therefore, the second insulating layer obtained by etching has a shape of an inverted trapezoid, which is more beneficial to disconnecting the first trace and the second trace from each other.

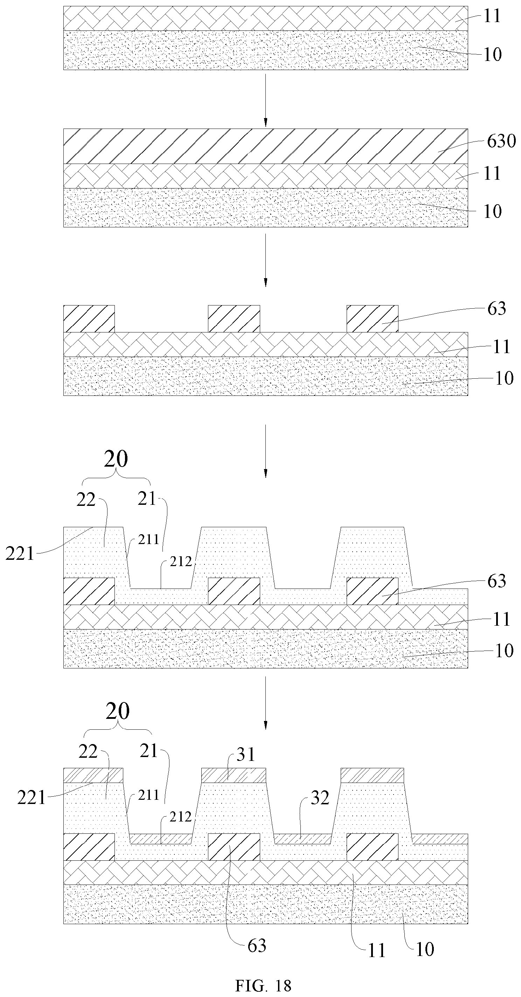

According to an embodiment of the present disclosure, referring to FIG. 18, before forming the first original insulating layer, the method for manufacturing a display panel further includes:
S610: forming a third original insulating layer 630, that is, forming the third original insulating layer 630 on a side of the first pixel circuits 11 away from the base substrate 10;
S620: etching the third original insulating layer 630, to obtain a patterned third insulating layer 63. An orthographic projection of the first insulating layer 20 on the base substrate 10 covers an orthographic projection of the third insulating layer 63 on the base substrate 10, and there is no overlapping (there is a non-overlapping region) between the orthographic projection of the third insulating layer 63 on the base substrate 10 and an orthographic projection of the groove 21 on the base substrate 10. Therefore, by providing the third insulating layer, the step between the top surface 221 of the protrusion 22 and the bottom surface 212 of the groove 21 of the first insulating layer 20, that is, the step between the first trace and the second trace, can be further increased, so that when the traces are formed by a deposition process, the first traces and the second traces can be more easily and completely disconnected from each other.

It will be appreciated by one of ordinary skill in the art that the first original insulating layer is formed only after the third insulating layer is formed, and then the first insulating layer is obtained by etching the first original insulating layer.

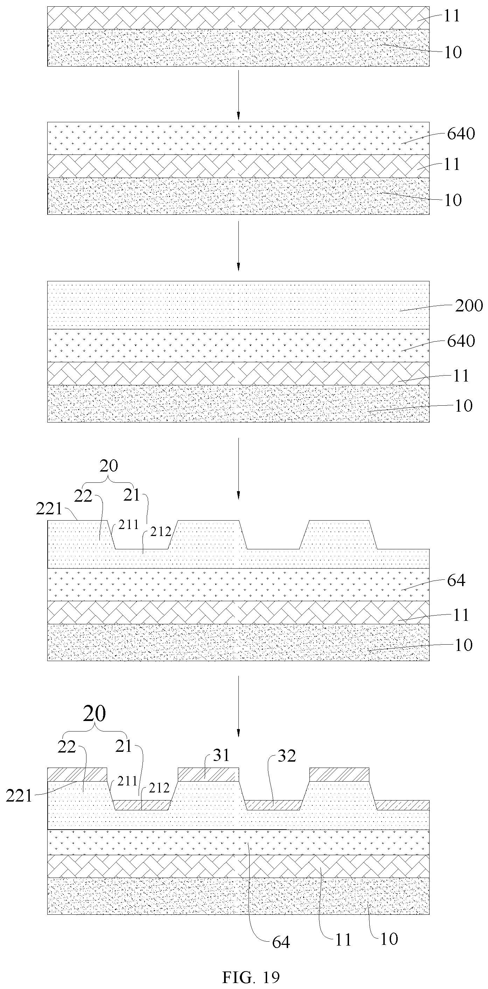

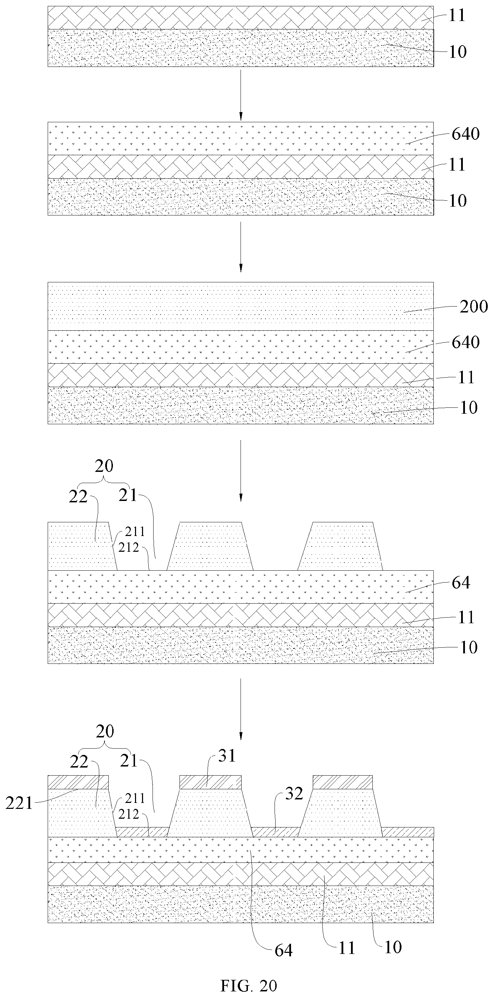

According to an embodiment of the present disclosure, referring to FIGS. 19 and 20, the method for manufacturing a display panel further includes: forming a fourth original insulating layer 640 before the first original insulating layer 200 is formed, wherein the first original insulating layer 200 is formed on a surface of the fourth original insulating layer 640 away from the base substrate. Therefore, the disconnection between the first trace and the second trace can still be effectively realized.

When the first original insulating layer is etched to form the first insulating layer 20 provided with the grooves 21 therein, in some embodiments, the grooves 21 do not penetrate through the first insulating layer 20, as shown in FIG. 19, the second traces 32 are formed on the bottom surfaces 212 of the grooves 21; in other embodiments, referring to FIG. 20, the grooves 21 penetrate through the first insulating layer 20, and the second traces 32 are disposed on a surface of the fourth insulating layer 64 exposed by the grooves 21. **In** this case, the grooves penetrate through the first insulating layer, so that the step between the first trace 31 and the second trace 32 can be further increased, the first trace and the second trace can be better ensured to be completely and thoroughly disconnected from each other, and the product yield is further improved. It should be noted that the fourth original insulating layer 640, without being etched for patterning, is the fourth insulating layer 64.

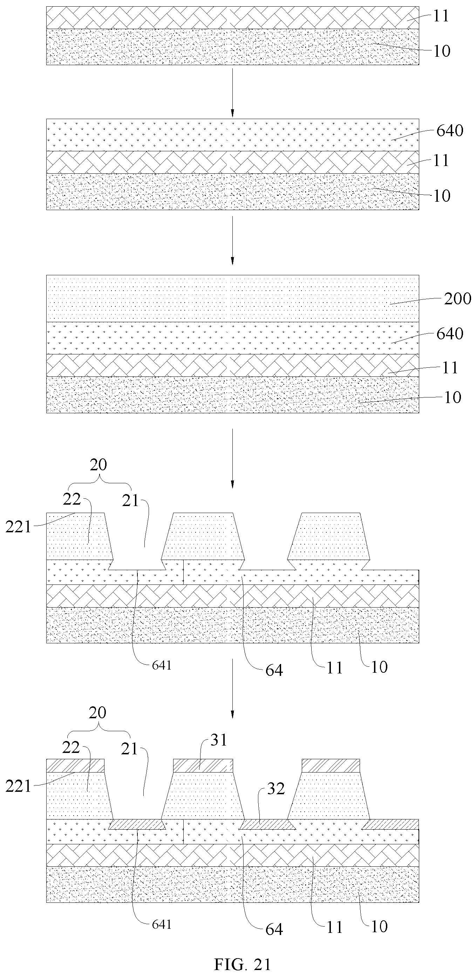

According to an embodiment of the present disclosure, referring to FIG. 21, the method for manufacturing a display panel further includes: etching the first original insulating layer 200 and the fourth original insulating layer 640 (i.e., the first original insulating layer and the second original insulating layer are simultaneously etched through a single etching step), to simultaneously obtain the first insulating layer 20 provided with the grooves 21 therein and the fourth insulating layer 64 provided with the concave portions 641 therein, where the grooves 21 penetrate through the first insulating layer 20, an orthographic projection of each groove 21 on the base substrate 10 and an orthographic projection of the corresponding concave portion 641 on the base substrate 10 have an overlapping region therebetween, and each second trace 32 is formed on a bottom surface of the corresponding concave portion 641. Thus, by providing the concave portions 641, the step between the first trace 31 and the second trace 32 can be further increased, the first trace and the second trace can be better ensured to be completely and thoroughly disconnected from each other, and the product yield is further improved.

It can be understood by one of ordinary skill in the art that the above method for manufacturing a display panel can be used to manufacture the above display panel, wherein in the above manufacturing method, the requirements for the structures of the first insulating layer, the second insulating layer, the third insulating layer, the fourth insulating layer, the grooves, the concave portions, the first pixel circuits, the light emitting devices, and the like are the same as those described above, and therefore, the description thereof is omitted here.

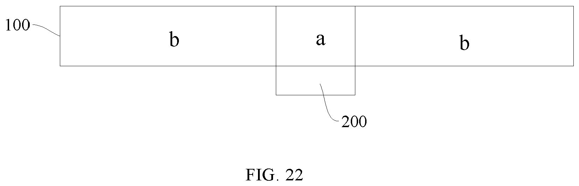

In yet another aspect of the present disclosure, the present disclosure provides a display apparatus. According to an embodiment of the present disclosure, referring to FIG. 22, the display apparatus includes the above display panel 100; the display panel 100 includes a first display region b and a second display region a; the display panel 100 includes an under-screen functional region (not shown), and an orthographic projection of the under-screen functional region on the display panel 100 and an orthographic projection of the first display region b on the display panel 100 have an overlapping region therebetween. The under-screen functional region may be provided with an under-screen functional layer structure 200 therein. That is, the under-screen functional region is a transverse coverage region for the under-screen functional layer structure. That is, for the under-screen functional layer structure 200, the under-screen functional region of the display panel 100 is formed in a horizontal direction. Therefore, a large-sized under-screen functional layer can be designed in the display apparatus. It will be understood by one of ordinary skill in the art that the display apparatus has all the characteristics and advantages of the display panel described above, which will not be described herein in detail.

There is no special requirement for the specific structure of the under-screen functional layer structure, which can be freely selected by one of ordinary skill in the art according to an actual design requirement. In some embodiments, an under-screen camera is provided in the under-screen functional region. The above structure of the display panel of the present disclosure can meet the requirement of the under-screen camera for the high light transmittance and can realize the design requirement of the large-sized under-screen camera.

According to the embodiment of the present disclosure, there is no special requirement on the specific type of the display apparatus, and one of ordinary skill in the art can flexibly select the display apparatus according to actual requirements. For example, the display apparatus may be a mobile phone, an iPad, a notebook, or the like.

As can be understood by one of ordinary skill in the art, the display apparatus has essential structures and components of a conventional display apparatus besides the display panel and the under-screen functional region. For example, besides the display panel and the under-screen functional layer, a mobile phone may include the essential structures and components, such as a battery back cover, a middle frame, a touch panel, an audio module, a main board, and the like.

The terms "first" and "second" are used herein for descriptive purposes only and are not to be construed as indicating or implying relative importance or to implicitly indicate the number of technical features indicated. Thus, a feature defined by "first" or "second" may include one or more of the features explicitly or implicitly. In the description of the present invention, "a plurality" means two or more, unless specifically defined otherwise.

In the description of the present specification, reference to the description of "one embodiment", "some embodiments", "an example", "a specific example", or "some examples" or the like means that a particular feature, structure, material, or characteristic described in connection with the embodiment or example is included in at least one embodiment or example of the present disclosure. In this specification, the schematic representations of the above terms are not necessarily intended to refer to the same embodiment or example. Furthermore, the particular features, structures, materials, or characteristics described may be combined in any suitable manner in any one or more embodiments or examples. Moreover, various embodiments or examples and features thereof described in this specification can be combined and merged by one of ordinary skill in the art without conflicting with each other.

While embodiments of the present disclosure have been shown and described above, it will be understood that the above embodiments are exemplary and not to be construed as limiting the present disclosure, and that changes, modifications, substitutions and alterations may be made to the above embodiments by one of ordinary skill in the art within the scope of the present disclosure.

## Claims

1. A display panel, comprising:
a base substrate (10);
a first insulating layer (20) on a side of the base substrate (10); wherein the first insulating layer (20) comprises a plurality of grooves (21) and a plurality of protrusions (22) on a side of the first insulating layer (20) away from the base substrate (10) and alternately arranged in sequence; each groove (21) comprises a side wall (211) and a bottom surface (212), and each protrusion (22) comprises a top surface (221); and
traces (30) on the side of the first insulating layer (20) away from the base substrate (10), wherein the traces (30) comprise first traces (31) and second traces (32), each first trace (31) is on a side of the top surface (221) of the corresponding protrusion (22) away from the base substrate (10), each second trace (32) is on the bottom surface (212) of the corresponding groove (21), and the first traces (31) are disconnected from the second traces (32);
**characterized in that**
the display panel further comprises a first display region (b) and a second display region (a) at an outer edge of the first display region (b), wherein the display panel comprises:
a plurality of first pixel circuits (11) between the base substrate (10) and the first insulating layer (20) and in the second display region (a); and
light emitting devices (40) on a side of the traces (30) away from the base substrate (10) and in the first display region (b), wherein each trace (30) is used for electrically connecting the corresponding first pixel circuit (11) and the corresponding light emitting device (40), so that the first pixel circuit (11) drives the corresponding light emitting device (40) to emit light.

2. The display panel according to claim 1, wherein an angle (α) between the side wall (211) of each groove (21) and a plane where the bottom surface (212) of the groove (21) is located is in a range from 65° to 90°, and a depth of each groove (21) is in a range from 100 nm to 480 nm;
a horizontal distance (d) between the first trace (31) and the second trace (32) adjacent to each other is in a range from 1.8 µm to 2.5 µm; or
the plurality of grooves (21) do not penetrate through the first insulating layer (20), and a thickness of the first insulating layer (20) at the bottom surface (212) is in a range from 20 nm to 50 nm.

3. The display panel according to claim 1 or 2, wherein the display panel further comprises an under-screen functional region, and an orthographic projection of the first display region (b) on the base substrate (10) overlaps with an orthographic projection of the under-screen functional region on the base substrate (10).

4. The display panel according to claim 1 or 2, further comprising:
a second insulating layer (62) on a surface of the first insulating layer (20) away from the base substrate (10) and provided with through holes (621) penetrating through the second insulating layer (62) therein, wherein an orthographic projection of each through hole (621) on the base substrate (10) overlaps with an orthographic projection of the corresponding groove (21) on the base substrate (10), and the first traces (31) are on a surface of the second insulating layer (62) away from the base substrate (10).

5. The display panel according to claim 4, wherein an angle (β) between a side wall (211) of each through hole (621) and a plane where the second insulating layer (62) is located is an obtuse angle;
the second insulating layer (62) has a thickness in a range from 150 nm to 500 nm; or
materials of the first insulating layer (20) and the second insulating layer (62) are different from each other.

6. The display panel according to claim 5, wherein the material of the first insulating layer (20) comprises silicon nitride, and the material of the second insulating layer (62) comprises silicon oxide.

7. The display panel according to claim 1 or 2, further comprising:
a third insulating layer (63) on a surface of the first insulating layer (20) close to the base substrate (10), wherein an orthographic projection of the first insulating layer (20) on the base substrate (10) covers an orthographic projection of the third insulating layer (63) on the base substrate (10), and the orthographic projection of the third insulating layer (63) on the base substrate (10) does not overlap with an orthographic projection of each groove (21) on the base substrate (10) to have a non-overlapping region therebetween.

8. The display panel according to claim 1 or 2, further comprising:
a fourth insulating layer (64) on a surface of the first insulating layer (20) close to the base substrate (10), wherein an orthographic projection of the fourth insulating layer (64) on the base substrate (10) covers an orthographic projection of each groove (21) on the base substrate (10).

9. The display panel according to claim 8, wherein the plurality of grooves (21) penetrate through the first insulating layer (20), and the second traces (32) are on a surface of the fourth insulating layer (64) exposed by the plurality of grooves (21).

10. The display panel according to claim 9, wherein the fourth insulating layer (64) comprises concave portions (641) therein, an orthographic projection of each groove (21) on the base substrate (10) overlaps with an orthographic projection of the corresponding concave portion (641) on the base substrate (10); each second trace (32) is on a bottom surface of the corresponding concave portion (641).

11. A method for manufacturing a display panel, comprising:
providing a base substrate (10);
forming a first original insulating layer (200) on a side of the base substrate (10);
etching the first original insulating layer (200) to obtain a first insulating layer (20) comprising a plurality of grooves (21) and a plurality of protrusions (22) alternately arranged in sequence, wherein each groove (21) comprises a side wall (211) and a bottom surface (212), and each protrusion (22) comprises a top surface (221); and
forming traces (30) on a side of the first insulating layer (20) away from the base substrate (10), wherein the traces (30) comprise first traces (31) and second traces (32), each first trace (31) is on a side of the top surface (221) of the corresponding protrusion (22) away from the base substrate (10), each second trace (32) is on the bottom surface (212) of the corresponding groove (21), and the first traces (31) are disconnected from the second traces (32); and
**characterized in that**
the display panel comprises a first display region (b) and a second display region (a) disposed at an outer edge of the first display region (b), and wherein the method for manufacturing the display panel comprises:
forming a plurality of first pixel circuits (11) on a surface of the base substrate (10) and located in the second display region (a);
forming the first insulating layer (20) on a side of the plurality of first pixel circuits (11) away from the base substrate (10);
forming the traces (30) on a side of the first insulating layer (20) away from the base substrate (10) by a deposition process; and
forming light emitting devices (40) on a side of the traces (30) away from the base substrate (10) and located in the first display region (b), wherein each trace (30) is used for electrically connecting the corresponding first pixel circuit (11) and the corresponding light emitting device (40), so that the first pixel circuit (11) drives the corresponding light emitting device (40) to emit light.

12. The method according to claim 11, wherein the etching the first original insulating layer (200) to obtain the first insulating layer (20), comprises:
forming a whole photoresist layer (70) on a surface of the first original insulating layer (200);
performing an exposure process and a development process on a predetermined region of the whole photoresist layer (70), to obtain a photoresist layer (71) having openings (72) therein; and
performing an etching process on a part of the first original insulating layer (200) exposed by the openings (72) by using an etching gas, to obtain the first insulating layer (20),
wherein an exposure amount in the exposure process is in a range from 100 mJ to 160 mJ, and a development time in the development is in a range from 40s to 80s; and/or
an etching rate in the etching process is in a range from 2500A/min to 3500A/min.

13. The method according to claim 12, comprising:
forming a second original insulating layer (620) on a surface of the first original insulating layer (200) away from the base substrate (10);
forming a whole photoresist layer (70) on a surface of the second original insulating layer (620);
exposing and developing a predetermined region of the whole photoresist layer (70), to obtain a photoresist layer (71) having openings (72) therein; and
etching the second original insulating layer (620) and the first original insulating layer (200) exposed by the openings (72) by using an etching gas, to obtain the second insulating layer (62) provided with the through holes (621) therein and the first insulating layer (20) provided with the plurality of grooves (21) therein, wherein an orthographic projection of each through hole (621) on the base substrate (10) overlaps with an orthographic projection of the corresponding groove (21) on the base substrate (10), and the first traces (31) are disposed on the surface of the second insulating layer (62) away from the base substrate (10).

14. The method according to claim 11, wherein prior to the forming the first original insulating layer (200), the method further comprises:
forming a third original insulating layer (630); and
etching the third original insulating layer (630) to obtain a patterned third insulating layer (63); wherein an orthographic projection of the first insulating layer (20) on the base substrate (10) covers an orthographic projection of the third insulating layer (63) on the base substrate (10), and the orthographic projection of the third insulating layer (63) on the base substrate (10) does not overlap with an orthographic projection of each groove (21) on the base substrate (10) to have a non-overlapping region therebetween; or
the method further comprises forming a fourth original insulating layer (640) before the forming the first original insulating layer (200), wherein the first original insulating layer (200) is formed on a surface of the fourth original insulating layer (640) away from the base substrate (10); and
etching the first original insulating layer (200) and the fourth original insulating layer (640), to obtain the first insulating layer (20) provided with the plurality of grooves (21) therein and the fourth insulating layer (64) provided with the concave portions (641) therein,
wherein the plurality of grooves (21) penetrate through the first insulating layer (20), an orthographic projection of each groove (21) on the base substrate (10) overlaps with an orthographic projection of the corresponding concave portion (641) on the base substrate (10), and each second trace (32) is formed on a bottom surface of the corresponding concave portion (641).

15. A display apparatus, comprising:
the display panel according to any one of claims 1 to 10, which comprises a first display region (b) and a second display region (a);
wherein the display panel comprises an under-screen functional region, and an orthographic projection of the under-screen functional region on the display panel overlaps with an orthographic projection of the first display region (b) on the display panel.

## Patentansprüche

1. Anzeigetafel, aufweisend:
ein Basissubstrat (10);
eine erste Isolierschicht (20) auf einer Seite des Basissubstrats (10); wobei die erste Isolierschicht (20) mehrere Nuten (21) und mehrere Vorsprünge (22) auf einer Seite der ersten Isolierschicht (20) aufweist, die von dem Basissubstrat (10) entfernt ist, und die aufeinanderfolgend abwechselnd angeordnet sind; jede Nut (21) eine Seitenwand (211) und eine Bodenfläche (212) aufweist und jeder Vorsprung (22) eine Oberseite (221) aufweist; und
Leiterbahnen (30) auf der Seite der ersten Isolierschicht (20), die von dem Basissubstrat (10) entfernt ist, wobei die Leiterbahnen (30) erste Leiterbahnen (31) und zweite Leiterbahnen (32) umfassen, jede erste Leiterbahn (31) sich auf einer Seite der Oberseite (221) des entsprechenden Vorsprungs (22) befindet, die von dem Basissubstrat (10) entfernt ist, jede zweite Leiterbahn (32) sich auf der Bodenfläche (212) der entsprechenden Nut (21) befindet und die ersten Leiterbahnen (31) von den zweiten Leiterbahnen (32) getrennt sind;
**dadurch gekennzeichnet, dass**
die Anzeigetafel ferner einen ersten Anzeigebereich (b) und einen zweiten Anzeigebereich (a) an einer Außenkante des ersten Anzeigebereichs (b) aufweist, wobei die Anzeigetafel aufweist:
mehrere erste Pixelschaltungen (11) zwischen dem Basissubstrat (10) und der ersten Isolierschicht (20) und in dem zweiten Anzeigebereich (a); und
lichtemittierende Vorrichtungen (40) auf einer Seite der Leiterbahnen (30), die von dem Basissubstrat (10) entfernt ist, und in dem ersten Anzeigebereich (b), wobei jede Leiterbahn (30) verwendet wird, um die entsprechende erste Pixelschaltung (11) und die entsprechende lichtemittierende Vorrichtung (40) elektrisch zu verbinden, so dass die erste Pixelschaltung (11) die entsprechende lichtemittierende Vorrichtung (40) zum Emittieren von Licht ansteuert.

2. Anzeigetafel nach Anspruch 1, wobei ein Winkel (a) zwischen der Seitenwand (211) jeder Nut (21) und einer Ebene, in der sich die Bodenfläche (212) der Nut (21) befindet, in einem Bereich von 65° bis 90° liegt und eine Tiefe jeder Nut (21) in einem Bereich von 100 nm bis 480 nm liegt;
ein horizontaler Abstand (d) zwischen der ersten Leiterbahn (31) und der zweiten Leiterbahn (32), die einander benachbart sind, in einem Bereich von 1,8 µm bis 2,5 µm liegt; oder die mehreren Nuten (21) nicht durch die erste Isolierschicht (20) hindurchgehen, und ein Dicke der ersten Isolierschicht (20) an der Bodenfläche (212) in einem Bereich von 20 nm bis 50 nm liegt.

3. Anzeigetafel nach Anspruch 1 oder 2, wobei die Anzeigetafel ferner einen Funktionsbereich unterhalb des Bildschirms aufweist und eine orthographische Projektion des ersten Anzeigebereichs (b) auf dem Basissubstrat (10) mit einer orthographischen Projektion des Funktionsbereichs unterhalb des Bildschirms auf dem Basissubstrat (10) überlappt.

4. Anzeigetafel nach Anspruch 1 oder 2, ferner aufweisend:
eine zweite Isolierschicht (62) auf einer Fläche der ersten Isolierschicht (20), die von dem Basissubstrat (10) entfernt ist, und mit Durchgangslöchern (621) versehen ist, die darin durch die zweite Isolierschicht (62) hindurchgehen, wobei eine orthographische Projektion jedes Durchgangslochs (621) auf dem Basissubstrat (10) mit einer orthographischen Projektion der entsprechenden Nut (21) auf dem Basissubstrat (10) überlappt und die ersten Leiterbahnen (31) auf einer Fläche der zweiten Isolierschicht (62), die von dem Basissubstrat (10) entfernt ist, angeordnet sind.

5. Anzeigetafel nach Anspruch 4, wobei ein Winkel (β) zwischen einer Seitenwand (211) jedes Durchgangslochs (621) und einer Ebene, in der sich die zweite Isolierschicht (62) befindet, ein stumpfer Winkel ist;
die zweite Isolierschicht (62) eine Dicke in einem Bereich von 150 nm bis 500 nm aufweist; oder
die Materialien der ersten Isolierschicht (20) und der zweiten Isolierschicht (62) voneinander verschieden sind.

6. Anzeigetafel nach Anspruch 5, wobei das Material der ersten Isolierschicht (20) Siliziumnitrid aufweist und das Material der zweiten Isolierschicht (62) Siliziumoxid aufweist.

7. Anzeigetafel nach Anspruch 1 oder 2, ferner aufweisend:
eine dritte Isolierschicht (63) auf einer Fläche der ersten Isolierschicht (20) nahe bei dem Basissubstrat (10), wobei eine orthographische Projektion der ersten Isolierschicht (20) auf dem Basissubstrat (10) eine orthographische Projektion der dritten Isolierschicht (63) auf dem Basissubstrat (10) bedeckt und die orthographische Projektion der dritten Isolierschicht (63) auf dem Basissubstrat (10) sich nicht mit einer orthographischen Projektion jeder Nut (21) auf dem Basissubstrat (10) überlappt, so dass zwischen ihnen ein nicht überlappender Bereich vorhanden ist.

8. Anzeigetafel nach Anspruch 1 oder 2, ferner aufweisend:
eine vierte Isolierschicht (64) auf einer Fläche der ersten Isolierschicht (20) nahe bei dem Basissubstrat (10), wobei eine orthographische Projektion der vierten Isolierschicht (64) auf dem Basissubstrat (10) eine orthographische Projektion jeder Nut (21) auf dem Basissubstrat (10) bedeckt.

9. Anzeigetafel nach Anspruch 8, wobei die mehreren Nuten (21) durch die erste Isolierschicht (20) hindurchgehen und die zweiten Leiterbahnen (32) auf einer Fläche der vierten Isolierschicht (64) angeordnet sind, die durch die mehreren Nuten (21) freigelegt ist.

10. Anzeigetafel nach Anspruch 9, wobei die vierte Isolierschicht (64) konkave Abschnitte (641) aufweist, wobei eine orthographische Projektion jeder Nut (21) auf dem Basissubstrat (10) mit einer orthographischen Projektion des entsprechenden konkaven Abschnitts (641) auf dem Basissubstrat (10) überlappt; wobei jede zweite Leiterbahn (32) sich auf einer Bodenfläche des entsprechenden konkaven Abschnitts (641) befindet.

11. Verfahren zur Herstellung einer Anzeigetafel, umfassend:
Vorsehen eines Basissubstrats (10);
Bilden einer ersten ursprünglichen Isolierschicht (200) auf einer Seite des Basissubstrats (10);
Ätzen der ersten ursprünglichen Isolierschicht (200), um eine erste Isolierschicht (20) zu erhalten, die mehrere Nuten (21) und mehrere Vorsprünge (22) aufweist, die aufeinanderfolgend abwechselnd angeordnet sind, wobei jede Nut (21) eine Seitenwand (211) und eine Bodenfläche (212) aufweist und jeder Vorsprung (22) eine Oberseite (221) aufweist; und
Bilden von Leiterbahnen (30) auf einer Seite der ersten Isolierschicht (20), die von dem Basissubstrat (10) entfernt ist, wobei die Leiterbahnen (30) erste Leiterbahnen (31) und zweite Leiterbahnen (32) umfassen, wobei sich jede erste Leiterbahn (31) auf einer Seite der Oberseite (221) des entsprechenden Vorsprungs (22) befindet, die von dem Basissubstrat (10) entfernt ist, wobei sich jede zweite Leiterbahn (32) auf der Bodenfläche (212) der entsprechenden Nut (21) befindet und die ersten Leiterbahnen (31) von den zweiten Leiterbahnen (32) getrennt sind; und
**dadurch gekennzeichnet, dass**
die Anzeigetafel einen ersten Anzeigebereich (b) und einen zweiten Anzeigebereich (a) aufweist, der an einer Außenkante des ersten Anzeigebereichs (b) angeordnet ist, und wobei das Verfahren zur Herstellung der Anzeigetafel umfasst:
Bilden mehrerer erster Pixelschaltungen (11) auf einer Fläche des Basissubstrats (10), die sich in dem zweiten Anzeigebereich (a) befinden;
Bilden der ersten Isolierschicht (20) auf einer Seite der mehreren ersten Pixelschaltungen (11), die von dem Basissubstrat (10) entfernt ist;
Bilden der Leiterbahnen (30) auf einer Seite der ersten Isolierschicht (20), die von dem Basissubstrat (10) entfernt ist, durch einen Abscheidungsvorgang; und
Bilden von lichtemittierenden Vorrichtungen (40) auf einer Seite der Leiterbahnen (30), die von dem Basissubstrat (10) entfernt ist und sich in dem ersten Anzeigebereich (b) befindet, wobei jede Leiterbahn (30) zum elektrischen Verbinden der entsprechenden ersten Pixelschaltung (11) und der entsprechenden lichtemittierenden Vorrichtung (40) verwendet wird, so dass die erste Pixelschaltung (11) die entsprechende lichtemittierende Vorrichtung (40) zum Emittieren von Licht ansteuert.

12. Verfahren nach Anspruch 11, wobei das Ätzen der ersten ursprünglichen Isolierschicht (200) zum Erhalten der ersten Isolierschicht (20) umfasst:
Bilden einer gesamten Fotolackschicht (70) auf einer Fläche der ersten ursprünglichen Isolierschicht (200);
Durchführen eines Belichtungsvorgangs und eines Entwicklungsvorgangs auf einem vorbestimmten Bereich der gesamten Fotolackschicht (70), um eine Fotolackschicht (71) mit Öffnungen (72) darin zu erhalten; und
Durchführen eines Ätzvorgangs an einem Teil der ersten ursprünglichen Isolierschicht (200), der durch die Öffnungen (72) freigelegt ist, unter Verwendung eines Ätzgas, um die erste Isolierschicht (20) zu erhalten,
wobei eine Belichtungsmenge in dem Belichtungsvorgang in einem Bereich von 100 mJ bis 160 mJ liegt und eine Entwicklungszeit in der Entwicklung in einem Bereich von 40 s bis 80 s liegt; und/oder
eine Ätzrate in dem Ätzvorgang in einem Bereich von 2500 A/min bis 3500 A/min liegt.

13. Verfahren nach Anspruch 12, umfassend:
Bilden einer zweiten ursprünglichen Isolierschicht (620) auf einer Fläche der ersten ursprünglichen Isolierschicht (200), die von dem Basissubstrat (10) entfernt ist;
Bilden einer gesamten Fotolackschicht (70) auf einer Fläche der zweiten ursprünglichen Isolierschicht (620);
Belichten und Entwickeln eines vorbestimmten Bereichs der gesamten Fotolackschicht (70), um eine Fotolackschicht (71) mit Öffnungen (72) darin zu erhalten; und
Ätzen der zweiten ursprünglichen Isolierschicht (620) und der ersten ursprünglichen Isolierschicht (200), die durch die Öffnungen (72) unter Verwendung eines Ätzgases freigelegt werden, um die zweite Isolierschicht (62) mit den Durchgangslöchern (621) darin und die erste Isolierschicht (20), die mit den mehreren Nuten (21) versehen ist, zu erhalten, wobei eine orthographische Projektion jedes Durchgangslochs (621) auf dem Basissubstrat (10) mit einer orthographischen Projektion der entsprechenden Nut (21) auf dem Basissubstrat (10) überlappt und die ersten Leiterbahnen (31) auf der Fläche der zweiten Isolierschicht (62), die entfernt von dem Basissubstrat (10) ist, angeordnet werden.

14. Verfahren nach Anspruch 11, wobei das Verfahren vor dem Bilden der ersten ursprünglichen Isolierschicht (200) ferner umfasst:
Bilden einer dritten ursprünglichen Isolierschicht (630); und
Ätzen der dritten ursprünglichen Isolierschicht (630), um eine strukturierte dritte Isolierschicht (63) zu erhalten; wobei eine orthographische Projektion der ersten Isolierschicht (20) auf dem Basissubstrat (10) eine orthographische Projektion der dritten Isolierschicht (63) auf dem Basissubstrat (10) bedeckt und die orthographische Projektion der dritten Isolierschicht (63) auf dem Basissubstrat (10) sich nicht mit einer orthographischen Projektion jeder Nut (21) auf dem Basissubstrat (10) überlappt, um einen nicht überlappenden Bereich dazwischen zu haben; oder
das Verfahren ferner umfasst: Bilden einer vierten ursprünglichen Isolierschicht (640) vor dem Bilden der ersten ursprünglichen Isolierschicht (200), wobei die erste ursprüngliche Isolierschicht (200) auf einer Fläche der vierten ursprünglichen Isolierschicht (640) entfernt von dem Basissubstrat (10) gebildet wird; und
Ätzen der ersten ursprünglichen Isolierschicht (200) und der vierten ursprünglichen Isolierschicht (640), um die erste Isolierschicht (20) mit den mehreren Nuten (21) darin und die vierte Isolierschicht (64) mit den konkaven Abschnitten (641) darin zu erhalten,
wobei die mehreren Nuten (21) durch die erste Isolierschicht (20) hindurchgehen, eine orthographische Projektion jeder Nut (21) auf dem Basissubstrat (10) mit einer orthographischen Projektion des entsprechenden konkaven Abschnitts (641) auf dem Basissubstrat (10) überlappt und jede zweite Leiterbahn (32) auf einer Bodenfläche des entsprechenden konkaven Abschnitts (641) gebildet wird.

15. Anzeigevorrichtung, aufweisend:
die Anzeigetafel nach einem der Ansprüche 1 bis 10, die einen ersten Anzeigebereich (b) und einen zweiten Anzeigebereich (a) aufweist;
wobei die Anzeigetafel einen Funktionsbereich unterhalb des Bildschirms aufweist und eine orthographische Projektion des Funktionsbereichs unterhalb des Bildschirms auf der Anzeigetafel mit einer orthographischen Projektion des ersten Anzeigebereichs (b) auf der Anzeigetafel überlappt.

## Revendications

1. Panneau d'affichage, comprenant :
un substrat de base (10) ;
une première couche isolante (20) sur un côté du substrat de base (10) ; dans lequel la première couche isolante (20) comprend une pluralité de rainures (21) et une pluralité de saillies (22) sur un côté de la première couche isolante (20) éloigné du substrat de base (10) et disposées en alternance dans un ordre séquentiel ; chaque rainure (21) comprend une paroi latérale (211) et une surface inférieure (212), et chaque saillie (22) comprend une surface supérieure (221) ; et
des pistes (30) sur le côté de la première couche isolante (20) éloigné du substrat de base (10), dans lequel les pistes (30) comprennent des premières pistes (31) et des deuxièmes pistes (32), chaque première piste (31) se trouve sur un côté de la surface supérieure (221) de la saillie correspondante (22) éloignée du substrat de base (10), chaque deuxième piste (32) se trouve sur la surface inférieure (212) de la rainure correspondante (21), et les premières pistes (31) sont déconnectées des deuxièmes pistes (32) ;
**caractérisé en ce que**
le panneau d'affichage comprend en outre une première zone d'affichage (b) et une deuxième zone d'affichage (a) au niveau d'un bord extérieur de la première zone d'affichage (b), dans lequel le panneau d'affichage comprend :
une pluralité de premiers circuits de pixels (11) entre le substrat de base (10) et la première couche isolante (20) et dans la deuxième zone d'affichage (a) ; et
des dispositifs électroluminescents (40) sur un côté des pistes (30) éloigné du substrat de base (10) et dans la première zone d'affichage (b), chaque piste (30) étant utilisée pour connecter électriquement le premier circuit de pixel correspondant (11) et le dispositif électroluminescent correspondant (40), de sorte que le premier circuit de pixels (11) commande le dispositif électroluminescent correspondant (40) pour émettre de la lumière.

2. Panneau d'affichage selon la revendication 1, dans lequel un angle (α) entre la paroi latérale (211) de chaque rainure (21) et un plan où se trouve la surface inférieure (212) de la rainure (21) est compris entre 65° et 90°, et la profondeur de chaque rainure (21) est comprise entre 100 nm et 480 nm ;
Une distance horizontale (d) entre la première piste (31) et la deuxième piste (32) adjacentes l'une à l'autre est comprise entre 1,8 µm et 2,5 µm ; ou bien
la pluralité de rainures (21) ne pénètre pas à travers la première couche isolante (20), et l'épaisseur de la première couche isolante (20) au niveau de la surface inférieure (212) est comprise entre 20 nm et 50 nm.

3. Panneau d'affichage selon la revendication 1 ou 2, dans lequel le panneau d'affichage comprend en outre une région fonctionnelle sous l'écran, et une projection orthographique de la première région d'affichage (b) sur le substrat de base (10) chevauche une projection orthographique de la région fonctionnelle sous l'écran sur le substrat de base (10).

4. Panneau d'affichage selon la revendication 1 ou 2, comprenant en outre :
une deuxième couche isolante (62) sur une surface de la première couche isolante (20) éloignée du substrat de base (10) et pourvue de trous traversants (621) pénétrant à travers la deuxième couche isolante (62) à l'intérieur de celle-ci, dans lequel une projection orthographique de chaque trou traversant (621) sur le substrat de base (10) chevauche une projection orthographique de la rainure correspondante (21) sur le substrat de base (10), et les premières pistes (31) se trouvent sur une surface de la deuxième couche isolante (62) éloignée du substrat de base (10).

5. Panneau d'affichage selon la revendication 4, dans lequel un angle (β) entre une paroi latérale (211) de chaque trou traversant (621) et un plan où se trouve la deuxième couche isolante (62) est situé est un angle obtus ;
la deuxième couche isolante (62) a une épaisseur comprise entre 150 nm et 500 nm ; ou bien
les matériaux de la première couche isolante (20) et de la deuxième couche isolante (62) sont différents l'un de l'autre.

6. Panneau d'affichage selon la revendication 5, dans lequel le matériau de la première couche isolante (20) comprend du nitrure de silicium, et le matériau de la deuxième couche isolante (62) comprend de l'oxyde de silicium.

7. Panneau d'affichage selon la revendication 1 ou 2, comprenant en outre :
une troisième couche isolante (63) sur une surface de la première couche isolante (20) proche du substrat de base (10), dans lequel une projection orthographique de la première couche isolante (20) sur le substrat de base (10) recouvre une projection orthographique de la troisième couche isolante (63) sur le substrat de base (10), et la projection orthographique de la troisième couche isolante (63) sur le substrat de base (10) ne chevauche pas une projection orthographique de chaque rainure (21) sur le substrat de base (10) afin d'avoir une région sans chevauchement entre elles.

8. Panneau d'affichage selon la revendication 1 ou 2, comprenant en outre :
une quatrième couche isolante (64) sur une surface de la première couche isolante (20) proche du substrat de base (10), dans laquelle une projection orthographique de la quatrième couche isolante (64) sur le substrat de base (10) recouvre une projection orthographique de chaque rainure (21) sur le substrat de base (10).

9. Panneau d'affichage selon la revendication 8, dans lequel la pluralité de rainures (21) pénètrent à travers la première couche isolante (20), et les deuxièmes pistes (32) se trouvent sur une surface de la quatrième couche isolante (64) exposée par la pluralité de rainures (21).

10. Panneau d'affichage selon la revendication 9, dans lequel la quatrième couche isolante (64) comprend des parties concaves (641), une projection orthographique de chaque rainure (21) sur le substrat de base (10) chevauche une projection orthographique de la partie concave correspondante (641) sur le substrat de base (10) ; chaque deuxième piste (32) se trouve sur une surface inférieure de la partie concave correspondante (641).

11. Procédé de fabrication d'un panneau d'affichage, comprenant :
fournir un substrat de base (10) ;
former une première couche isolante d'origine (200) sur un côté du substrat de base (10) ;
graver la première couche isolante d'origine (200) pour obtenir une première couche isolante (20) comprenant une pluralité de rainures (21) et une pluralité de saillies (22) disposées en alternance dans l'ordre, dans lequel chaque rainure (21) comprend une paroi latérale (211) et une surface inférieure (212), et chaque saillie (22) comprend une surface supérieure (221) ; et
former des pistes (30) sur un côté de la première couche isolante (20) éloigné du substrat de base (10), dans lequel les pistes (30) comprennent des premières pistes (31) et des deuxièmes pistes (32), chaque première piste (31) se trouvant sur un côté de la surface supérieure (221) de la saillie correspondante (22) éloignée du substrat de base (10), chaque deuxième piste (32) se trouvant sur la surface inférieure (212) de la rainure correspondante (21), et les premières pistes (31) étant déconnectées des deuxièmes pistes (32) ; et
**caractérisé en ce que**
le panneau d'affichage comprend une première zone d'affichage (b) et une deuxième zone d'affichage (a) disposée au niveau d'un bord extérieur de la première zone d'affichage (b), et dans lequel le procédé de fabrication du panneau d'affichage comprend :
former une pluralité de premiers circuits de pixels (11) sur une surface du substrat de base (10) et situés dans la deuxième zone d'affichage (a) ;
former la première couche isolante (20) sur un côté de la pluralité de premiers circuits de pixels (11) éloigné du substrat de base (10) ;
former les pistes (30) sur un côté de la première couche isolante (20) éloigné du substrat de base (10) par un processus de dépôt ; et
former des dispositifs électroluminescents (40) sur un côté des pistes (30) éloigné du substrat de base (10) et situé dans la première région d'affichage (b), dans lequel chaque piste (30) est utilisée pour connecter électriquement le premier circuit de pixels correspondant (11) et le dispositif électroluminescent correspondant (40), de sorte que le premier circuit de pixels (11) commande le dispositif électroluminescent correspondant (40) pour émettre de la lumière.

12. Procédé selon la revendication 11, dans lequel la gravure de la première couche isolante d'origine (200) pour obtenir la première couche isolante (20) comprend :
former une couche photorésistante complète (70) sur une surface de la première couche isolante d'origine (200) ;
réaliser un processus d'exposition et un processus de développement sur une région prédéterminée de la couche photorésistante entière (70), afin d'obtenir une couche photorésistante (71) comportant des ouvertures (72) ; et
réaliser un processus de gravure sur une partie de la première couche isolante d'origine (200) exposée par les ouvertures (72) à l'aide d'un gaz de gravure, afin d'obtenir la première couche isolante (20),
dans lequel la quantité d'exposition dans le processus d'exposition est comprise entre 100 mJ et 160 mJ, et le temps de développement dans le développement est compris entre 40 s et 80 s ; et/ou
un taux de gravure dans le processus de gravure est comprise entre 2500 A/min et 3500 A/min.

13. Procédé selon la revendication 12, comprenant :
Former une deuxième couche isolante d'origine (620) sur une surface de la première couche isolante d'origine (200) éloignée du substrat de base (10) ;
former une couche photorésistante entière (70) sur une surface de la deuxième couche isolante d'origine (620) ;
exposer et développer une région prédéterminée de la couche de photoréserve entière (70), afin d'obtenir une couche de photoréserve (71) comportant des ouvertures (72) ; et
graver la deuxième couche isolante d'origine (620) et la première couche isolante d'origine (200) exposées par les ouvertures (72) à l'aide d'un gaz de gravure, afin d'obtenir la deuxième couche isolante (62) pourvue de trous traversants (621) et la première couche isolante (20) pourvue d'une pluralité de rainures (21), dans laquelle une projection orthographique de chaque trou traversant (621) sur le substrat de base (10) chevauche une projection orthographique de la rainure correspondante (21) sur le substrat de base (10), et les premières pistes (31) sont disposées sur la surface de la deuxième couche isolante (62) à distance du substrat de base (10).

14. Procédé selon la revendication 11, dans lequel, avant la formation de la première couche isolante d'origine (200), le procédé comprend en outre :
former une troisième couche isolante d'origine (630) ; et
graver la troisième couche isolante d'origine (630) pour obtenir une troisième couche isolante à motifs (63) ; dans laquelle une projection orthographique de la première couche isolante (20) sur le substrat de base (10) recouvre une projection orthographique de la troisième couche isolante (63) sur le substrat de base (10), et la projection orthographique de la troisième couche isolante (63) sur le substrat de base (10) ne chevauche pas une projection orthographique de chaque rainure (21) sur le substrat de base (10) afin d'avoir une région sans chevauchement entre elles ; ou bien
le procédé comprend en outre la formation d'une quatrième couche isolante d'origine (640) avant la formation de la première couche isolante d'origine (200), dans laquelle la première couche isolante d'origine (200) est formée sur une surface de la quatrième couche isolante d'origine (640) éloignée du substrat de base (10) ; et
graver la première couche isolante d'origine (200) et de la quatrième couche isolante d'origine (640), afin d'obtenir la première couche isolante (20) pourvue d'une pluralité de rainures (21) et la quatrième couche isolante (64) pourvue de parties concaves (641),
dans lequel la pluralité de rainures (21) pénètrent à travers la première couche isolante (20), une projection orthographique de chaque rainure (21) sur le substrat de base (10) chevauche une projection orthographique de la partie concave correspondante (641) sur le substrat de base (10), et chaque deuxième piste (32) est formée sur une surface inférieure de la partie concave correspondante (641).

15. Dispositif d'affichage, comprenant :
le panneau d'affichage selon l'une quelconque des revendications 1 à 10, qui comprend une première région d'affichage (b) et une deuxième région d'affichage (a) ;
dans lequel le panneau d'affichage comprend une région fonctionnelle sous-écran, et une projection orthographique de la région fonctionnelle sous-écran sur le panneau d'affichage chevauche une projection orthographique de la première région d'affichage (b) sur le panneau d'affichage.
